# EUROPEAN PATENT APPLICATION

(11) **EP 3 881 765 A1**
(43) Date of publication of application: **22.09.2021**
(21) Application number: 21163285.6
(22) Date of filing: 17.03.2021
(51) Int. Cl.: A61B 5/242, G01R 33/26

(54) **MAGNETIC MEASURING SYSTEM AND MAGNETIC MEASURING DEVICE**

(30) Priority: 18.03.2020 JP 2020047389; 18.03.2020 JP 2020047390
(71) Applicant: Ricoh Company, Ltd., Tokyo 143-8555 (JP)
(72) Inventor: MIFUNE, Hironobu, Tokyo, 143-8555 (JP); OSAKA, Takanobu, Tokyo, 143-8555 (JP)
(74) Representative: Watkin, Timothy Lawrence Harvey

(57) **Abstract**

A magnetic measuring system includes an optical pumping atomic magnetometer measuring a magnetic field emanated from a subject to be measured, an external coil disposed around the optical pumping atomic magnetometer, an external coil driver configured to drive the external coil, and a stimulation application device configured to apply stimulation to the subject to be measured, wherein the external coil driver outputs a plurality of types of command values to the external coil, wherein the plurality of types of the command values is set so that a center frequency in a frequency characteristic of the optical pumping atomic magnetometer differs in response to an operation of the external coil in accordance with the command value, and the external coil driver sequentially changes the command value output to the external coil in response to the applying of the stimulation to the subject to be measured.

## Description

### BACKGROUND OF THE INVENTION

### 1. Field of the Invention

The present invention relates to a magnetic measuring system and a magnetic measuring device.

### 2. Description of the Related Art

The magnetic field generated by a living body is called the biomagnetism. A magnetic sensor called magnetic sensors used in room temperature, which do not need to be cooled with liquid Helium, to detect biomagnetism has begun in recent years. In particular, an optical pumping atomic magnetometer (OPM) using optical pumping are considered promising for measuring biomagnetism (performing biomagnetism measurement) from the viewpoints of sensitivity, size, and portability (for example, Patent Document 1).

### [Patent Documents]

[Patent Document 1] Japanese patent publication No. 6222974

### SUMMARY OF THE INVENTION

However, an optical pumping atomic magnetometer has high sensitivity enough to detect a weak magnetic field emanating from a living body such as a heart and brain. However, there is a problem that such high sensitivity can be obtained at a low frequency band and within a narrow bandwidth.

It is an object of the present invention to allow the optical pumping atomic magnetometer to measure magnetic fields over a wider range of frequency bands.

One aspect of the embodiments of the present invention may be to provide a magnetic measuring system including an optical pumping atomic magnetometer measuring a magnetic field emanated from a subject to be measured, an external coil disposed around the optical pumping atomic magnetometer, an external coil driver configured to drive the external coil, and a stimulation application device configured to apply stimulation to the subject to be measured, wherein the external coil driver outputs a plurality of types of command values to the external coil, wherein the plurality of types of the command values is set so that a center frequency in a frequency characteristic of the optical pumping atomic magnetometer differs in response to an operation of the external coil in accordance with the command value, and the external coil driver sequentially changes the command value output to the external coil in response to the applying of the stimulation to the subject to be measured.

### BRIEF DESCRIPTION OF THE DRAWINGS

FIG. 1 is a block diagram illustrating a schematic structure of a magnetic measuring system according to a first embodiment.
FIG. 2 illustrates a comparison of the frequency band of a conventional OPM and a frequency characteristic of a subject to be measured.
FIG. 3 is a diagram comparing the frequency band of the OPM in this embodiment with the frequency characteristic of the subject to be measured.
FIG. 4 is a block diagram illustrating a schematic structure of the magnetic measuring system according to a second embodiment.
FIG. 5 is a diagram illustrating an example of frequency characteristic change timing, taking into account stimulation application and magnetic field variation.
FIG. 6 is a schematic view illustrating a schematic structure of the magnetic measuring system according to a third embodiment.
FIG. 7 is a perspective view of the OPM and the cylindrical member illustrated in FIG. 6
FIG. 8 is a diagram illustrating a first pattern of current application to multiple OPMS.
FIG. 9 is a diagram illustrating a second pattern of current application to the multiple OPMS.
FIG. 10 is a diagram illustrating a third pattern of current application to the multiple OPMS.
FIG. 11 is a diagram illustrating a first arrangement pattern of the multiple OPMS.
FIG. 12 is a diagram illustrating a second arrangement pattern of the multiple OPMS 10.
FIG. 13 is a diagram illustrating a third arrangement pattern of the multiple OPMS 10.
FIG. 14 is a diagram illustrating a second arrangement pattern of the multiple OPMS 10.
FIG. 15 is a waveform diagram of the applied current during calibration of a single OPM.
FIG. 16 is a frequency characteristic of the single OPM when a current is applied as illustrated in FIG. 15.
FIG. 17 is an enlarged view of a vicinity of a magnetic field signal illustrated in FIG. 16.
FIG. 18 is a waveform diagram of the applied current during calibration of the multiple OPMS.
FIG. 19 illustrates the frequency characteristic of the multiple OPMS when the current illustrated in FIG. 18 is applied.
FIG. 20 is an enlarged view of the vicinity of the magnetic field signal illustrated in FIG. 19.
FIG. 21 is a diagram illustrating a schematic structure of the magnetic measuring device according to a fourth embodiment.
FIG. 22 is a diagram illustrating an example of the current application pattern of applying a current to the external coil.
FIG. 23 is a diagram illustrating an example of the shape of the external coil.
FIG. 24 is a diagram illustrating another example of the shape of the external coil.
FIG. 25 is a diagram illustrating another example of the shape of the external coil.
FIG. 26 is a perspective view schematically illustrating the structure of the OPM.
FIG. 27 is a perspective view schematically illustrating the structure of the OPM.
FIG. 28 is a perspective view illustrating an example of a structure of a magnetic measuring device.
FIG. 29 is a diagram illustrating an example of the internal structure of the optical pumping atomic magnetometer
FIG. 30 illustrates the frequency characteristics of outputs from the first and second OPM.
FIG. 31 is a diagram illustrating the frequency characteristics of outputs from each sensor when three OPMS are used.
FIG. 32 illustrates a mode in which the frequency characteristic of outputs from the first and second OPMS are superposed.
FIG. 33 illustrates waveforms of currents applied to each OPM.
FIG. 34 illustrates the frequency characteristic of the OPM when the current illustrated in FIG. 33 is applied.
FIG. 35 is an enlarged view of a vicinity of the magnetic field signal illustrated in FIG. 34
FIG. 36 illustrates an example of a gain adjustment of frequency characteristics of the first OPM and the second OPM.
FIG. 37 is a schematic diagram of the two OPMS which approach each other.
FIG. 38 is a schematic diagram of the two OPMS which distance each other
FIG. 39 is a schematic diagram of the two OPMS arranged by changing directions in which the coils face each other.
FIG. 40 is a diagram illustrating an example in which four OPMS are arranged so that external coils face in the same direction.
FIG. 41 is a diagram illustrating an example of a current application control in the structure illustrated in FIG. 40.
FIG. 42 is a diagram illustrating a first current application pattern of a drive control between adjacent OPMS.
FIG. 43 is a diagram illustrating a second current application pattern of the drive control between adjacent OPMS.
FIG. 44 is a diagram illustrating an example of the arrangement of the multiple OPMS when the shape to be measured is a curved surface.
FIG. 45 is a diagram illustrating a first arrangement pattern of multiple OPMS.
FIG. 46 is a diagram illustrating the first arrangement pattern having three types of OPMS.
FIG. 47 is a diagram illustrating a second arrangement pattern of the multiple OPMS.
FIG. 48 is a diagram illustrating a third arrangement pattern of the multiple OPMS.
FIG. 49 is a diagram illustrating a fourth arrangement pattern of the multiple OPMS.
FIG. 50 is a diagram illustrating a fourth arrangement pattern of the multiple OPMS.
FIG. 51 is a diagram illustrating a fifth arrangement pattern of the multiple OPMS.
FIG. 52 is a diagram illustrating a sixth arrangement pattern of the multiple OPMS.
FIG. 53 is a diagram illustrating another structure example of an external coil driver.
FIG. 54 is a diagram illustrating an example of a biomagnetic measuring system using a magnetic measuring device.

### DETAILED DESCRIPTION OF THE PREFERRED EMBODIMENTS

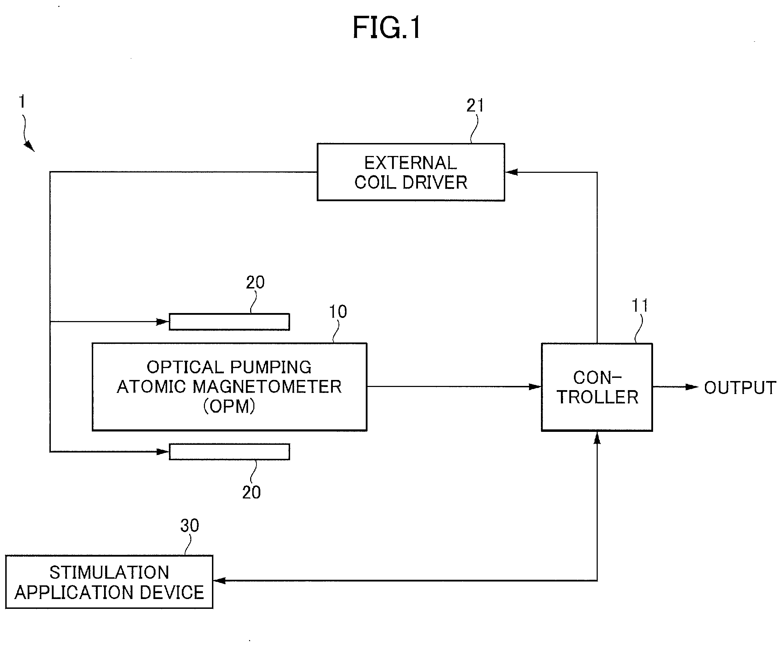

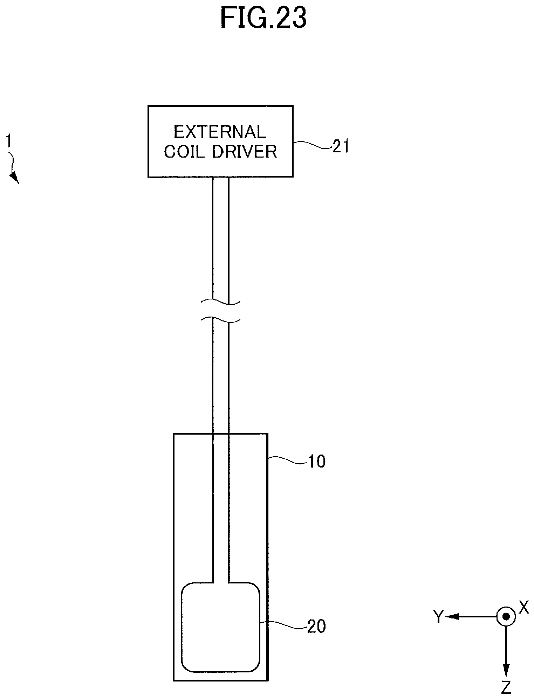

A description is given below, with reference to the FIG. 1 through FIG. 54 of embodiments of the present invention. Where the same reference symbols are attached to the same parts, repeated description of the parts is omitted.

Reference symbols typically designate as follows:
1, 1A, 1B: Magnetic measuring system;
2: Magnetic measuring device;
10; optical pumping atomic magnetometer (OPM);
11: Controller;
20: External coil;
21; External coil driver;
30: Stimulation application device;
40: Magnetic Sensor (Status detecting unit);
70: Environmental magnetic field reducing coil;
111: First OPM (Optical pumping atomic magnetometer);
112: Second OPM (Optical pumping atomic magnetometer);
211: First external coil;
212: Second external coil;
B, B1, B2: Frequency band of OPM output;
C1, C2, C3: Frequency characteristic of OPM;
F1, F2, F3: Center frequency of frequency characteristic;
j1, j2, j3, j4: Bias current; and
I1, I2, I#1, I#2: Magnetic field signals.

Hereinafter, embodiments will be described with reference to the accompanying drawings. In order to facilitate the understanding of the description, the same elements in each drawing are, as far as possible, designated by the same reference numerals, and the overlapping description is omitted.

### [First Embodiment]

A first embodiment will be described with reference to FIGS. 1 to 3. FIG. 1 is a block diagram illustrating a schematic structure of a magnetic measuring system 1 according to the first embodiment.

As illustrated in FIG. 1, the magnetic measuring system 1 includes an optical pumping atomic magnetometer 10, an external coil 20, a controller 11, an external coil driver 21, and a stimulation application device 30.

The optical pumping atomic magnetometer 10 measures the magnetic field of the subject to be measured. The optical pumping atomic magnetometer 10 includes a gas cell containing an alkali metal gas, a semiconductor laser as a light source, an optical element for detecting light, an optical element such as a lens or a waveplate, a heater for applying heat to the gas cell or a semiconductor laser, and a temperature detecting element for detecting temperature. The alkali metal enclosed in the gas cell may be cesium, rubidium, and potassium. The wavelength of the semiconductor laser, which is a light source, needs to be selected in conformity with the alkali metal to be used. The gas cell may use helium, neon, argon, etc. as a buffer gas in addition to alkali metal. Nitrogen may be encapsulated as a quench. The semiconductor laser is not located within the optical pumping atomic magnetometer 10, but may be located outside the optical pumping atomic magnetometer 10, and the light may be introduced into the optical pumping atomic magnetometer 10 through an optical fiber. Other types of lasers, such as solid state lasers and gas lasers, may be used if introduced by fiber. An optimum element is selected as the optical element in conformity with the wavelength of the semiconductor laser to be used. Regarding the photodetection element, an optimum element may be selected in conformity with the wavelength of the light source, such as a semiconductor laser, and electronic circuitry may be disposed inside the optical pumping atomic magnetometer 10 to execute processes, such as amplifying, the output signal from the photodetection element.

In the following description, the optical pumping atomic magnetometer 10 may be referred to as "OPM".

A pair of external coils 20 are positioned to face out of the optical pumping atomic magnetometer 10. The position of the external coil 20 is based on the position of the gas cell within the optical pumping atomic magnetometer 10. The external coil 20 is formed by arranging an electrical wire in a circular or square shape on a flat plate. The kind of magnetic field that is generated and the magnitude of the generated field are determined in advance, and the external coil 20 is formed accordingly.

The external coil driver 21 is a device for driving the external coil and supplies current to the external coil 20. The external coil driver 21 mainly includes a current generating unit for generating the current applied to the external coil 20, a recording unit for recording the current value applied, and a signal processing unit for determining the current value applied from the signals of the controller 11 and the recording unit, which will be described later.

In this embodiment, the external coil driver 21 outputs multiple types of command values to the external coil 20. These multiple types of command values are set so that the center frequencies of the frequency characteristics of the optical pumping atomic magnetometer 10 differ depending on the operation of the external coil 20 in accordance with the command values. The external coil driver 21 sequentially changes the command value to be output to the external coil 20 in accordance with the operation of the stimulation application device 30 to apply the stimulation to a subject to be measured. The operation of the external coil driver 21 will be described later.

The stimulation application device 30 applies the stimulation to the subject to be measured.
For example, a device that provides electrical stimulation to the subject to be measured, a device that provides visual information, a device that provides auditory information, and the like may apply a desired stimulation.

The controller 11 includes a signal processing circuit for determining the current or voltage value for driving the semiconductor laser within the optical pumping atomic magnetometer 10, the signal for driving heaters for the semiconductor laser and the gas cell at a set temperature, the current or voltage value for driving the semiconductor laser by receiving an output signal from the photodetection element, and a set temperature for applying to the semiconductor laser and the gas cell heater; an interface circuit for outputting a signal of the photodetection element to the outside of the controller; and an input and output circuit for the stimulation application device 30.

The operation of the magnetic measuring system 1 according to the first embodiment will be described.

The optical pumping atomic magnetometer 10 is placed in a magnetically shielded room or space to operate within a residual magnetic field having at most a certain intensity, and an environmental magnetic field reducing coil is disposed to further reduce the residual magnetic field to form a magnetic field region enabling an operation of the optical pumping atomic magnetometer 10.

The heaters of the gas cell of the optical pumping atomic magnetometer 10 and the heater of the semiconductor laser are set to a set value, and it is confirmed that a desired temperature is set using monitoring means respectively monitoring the heaters. The current value applied to the external coil 20 is determined in conformity with the frequency band of the magnetic field to be detected in advance, and the current value is applied to the external coil 20. An optical pumping atomic magnetometer 10 is positioned near the magnetic field source to be measured. An atom spin polarization occurs in response to the magnetic field to be generated, resulting in tilt of the polarization angle of the semiconductor laser that is transmitted through the gas cell, and a wavelength plate and a polarization plate are utilized to extract the signal of the photodetection element in conformity with the tilt of the polarization angle. This signal is converted into a magnetic field signal and the frequency is converted.

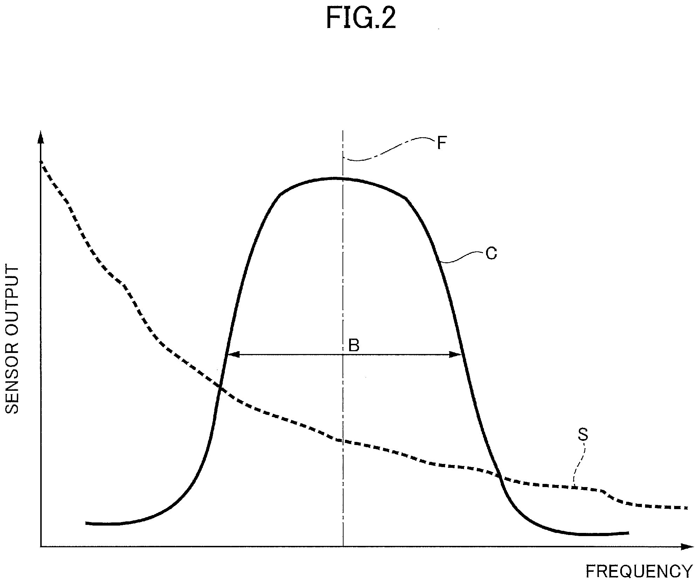

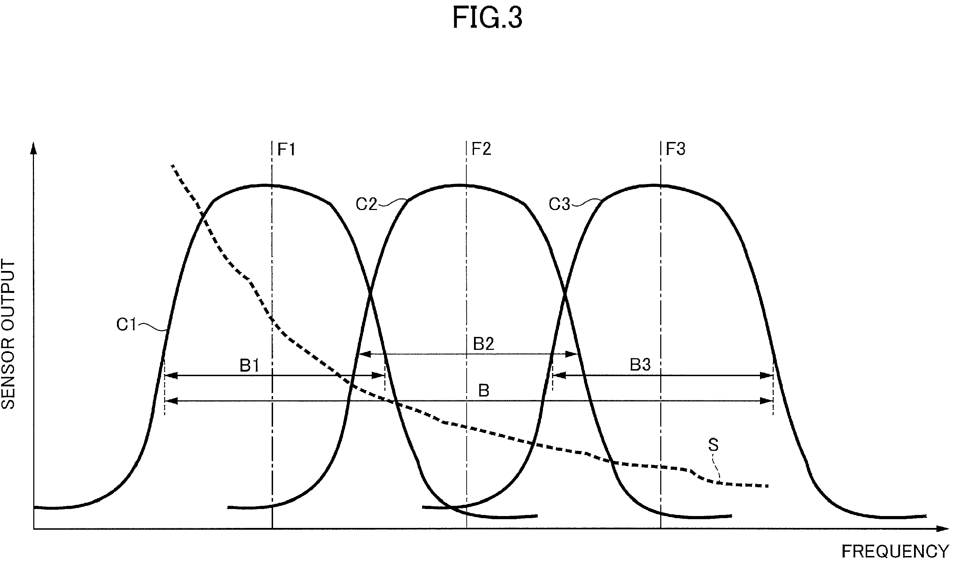

When the frequency band of the optical pumping atomic magnetometer 10 is narrow with respect to the frequency band of the magnetic field generated from the subject to be measured, the above measurement is repeated by changing the output value from the external coil driver so as to cover the frequency band of the magnetic field to be generated. Referring to FIGS. 2 and 3, this embodiment will be described. FIG. 2 is a diagram for comparing the frequency band B of the conventional OPM with the frequency characteristic S of the subject to be measured. FIG. 3 is a diagram for comparing the frequency band B of the OPM 10 according to this embodiment with the frequency characteristic S of the subject to be measured. The axis of abscissa of FIGS. 2 and 3 indicates the frequency and the axis of ordinate indicates the response (a sensor output). A solid line indicates the frequency characteristic C of the optical pumping atomic magnetometer 10, and a dashed line indicates the frequency characteristic S of the signal from the subject to be measured.

As illustrated in FIG. 2, in a conventional OPM, the frequency characteristic C of OPM is shaped like a mountain outline or a bell curve with an angle having the center frequency F as the apex. Therefore, the width of the frequency characteristic C (the measurable frequency band B) is narrow with respect to the width of the frequency characteristic S of the signal of the subject to be measured, and it is impossible to detect the entire frequency band of the signal of the subject to be measured.

Therefore, in this embodiment, as illustrated in FIG. 3, the entire frequency band of the signal of the subject to be measured can be detected by changing the center value of the frequency characteristic of the optical pumping atomic magnetometer 10. Because it is possible to determine the frequency band to a certain extent depending on the measurement portion of the subject to be measured, the measurement portion of the subject to be measured determines how to change the output value from the external coil driver 21, and detects the signal by changing the output value applied to the external coil 20 one after another.

FIG. 3 illustrates a case where the center value of the frequency characteristic is changed to three types in a single optical pumping atomic magnetometer 10. When the output value from the external coil driver 21 is O1, the frequency characteristic C1 of the optical pumping atomic magnetometer 10 has a center frequency of F1. When the output value from the external coil driver 21 is O2, the frequency characteristic C2 of the optical pumping atomic magnetometer 10 is the center frequency F2. When the output value from the external coil driver 21 is O3, the frequency characteristic C3 of the optical pumping atomic magnetometer 10 is the center frequency F3. The central frequencies F1 to F3 show a relationship of F1<F2<F3. These three frequency characteristics C1 to C3 can be set so that their respective frequency bands B1 to B3 overlap, for example, as illustrated in FIG. 3. Therefore, as illustrated in FIG. 3, the frequency band B of the optical pumping atomic magnetometer 10 can be widened over the entire interval from the lower limit value of the frequency band B1 to the upper limit value of the frequency band B3. Thus, in this embodiment, the frequency from the subject to be measured can be covered by the single optical pumping atomic magnetometer 10 by setting the center values F1 to F3 of the three frequency characteristics.

The timing of changing the center value F of the frequency characteristic C is such that a signal from the stimulation application device 30 is input to the controller 11 and output from the controller 11 to the external coil driver 21. This timing can be varied by an event to be measured, either simultaneously with or before and after the stimulation to the subject to be measured. That is, in this embodiment, when a stimulation is applied to a subject to be measured, the stimulation application device 30 transmits a signal to that effect to the control device 11, and the control device 11 transmits a signal to change the command value to that of the external coil driver 21 in response to the signal received from the stimulating application device 30. The external coil driver 21 sequentially changes the command value to that of the external coil 20 in order to change the center value F of the frequency characteristic C in response to a command from the controller 11.

The center value F of the frequency characteristic C of the optical pumping atomic magnetometer 10 may be changed from a low frequency to a high frequency (in the order of F1, F2, and F3) or from a high frequency to a low frequency (in the order of F3, F2, and F1) in a stepwise manner. Alternatively, a fine interval may be varied as close as possible to the frequency band of interest, and coarse interval may otherwise be used. There is a case where the high frequency band is required to be observed in detail when looking at a rise, the low frequency band may be sufficient with a rough grasp. In such a case, the center values of the frequency characteristic may have a fine interval in the high frequency band and the center values of the frequency characteristic may be a coarse interval in the low frequency band.

The output from the optical pumping atomic magnetometer 10 is input to the controller 11 as a time series signal. Within the controller 11, the time series output signal may be directly output from the optical pumping atomic magnetometer 10, or the time series output signal may be processed and output within the device for each center value F1 to F3 of each frequency characteristic. For processing, calibration for each of the frequency characteristics C1 to C3 and conversion of the signal into a time series signal may be performed after processing such as frequency space conversion and filtering. Further, the processing may be performed not by the control device 11 but by a processing device such as a computer.

In the magnetic measuring system 1 of the first embodiment, the external coil driver 21 can output multiple command values to the external coil 20 disposed around the optical pumping atomic magnetometer 10. These plural command values are set so that the center frequencies F of the frequency characteristics C of the optical pumping atomic magnetometer 10 differ depending on the operation of the external coil 20 in accordance with the command value. The external coil driver 21 sequentially changes the command value to output to the external coil 20 in accordance with the operation of the stimulation application device 30 to apply the stimulation to the subject to be measured. With this arrangement, the frequency characteristics of the single optical pumping atomic magnetometer 10 can be sequentially changed (e.g., the center frequencies are changed in the order of F1, F2, and F3 illustrated in FIG. 3) to increase the total measurable frequency band B by successively shifting the measurable frequency band B (e.g., the frequency band is changed in the order of B1, B2, and B3 illustrated in FIG. 3). As a result, the magnetic measuring system 1 according to the present embodiment can measure the magnetic field of the broader frequency band B by the optical pumping atomic magnetometer 10. Because the command value output to the external coil 20 is changed according to the application of a stimulation, the magnetic field of the subject to be measured by the OPM 10 can be measured in relation to the stimulation applied to the subject to be measured.

### [Second Embodiment]

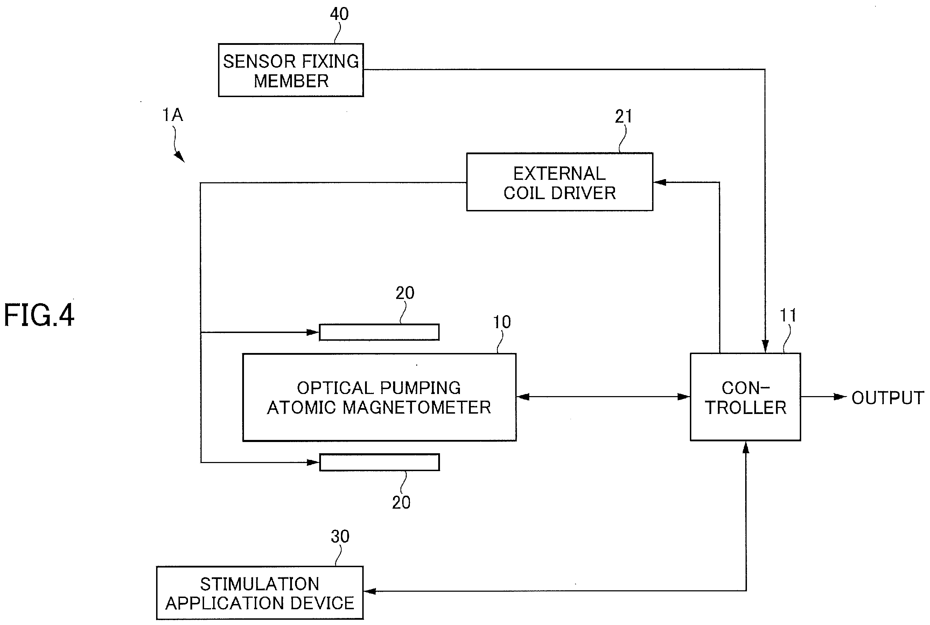

A second embodiment will be described with reference to FIG. 4. FIG. 4 is a block diagram illustrating a schematic structure of a magnetic measuring system 1A according to a second embodiment.

The magnetic measuring system 1A according to the second embodiment differs from the magnetic measuring system 1 according to the first embodiment in that the magnetic sensor 40 is provided as a state detecting unit for detecting the state of the subject to be measured.

The magnetic sensor 40 may be a sensor capable of detecting a magnetic field signal from an object (subject to be measured), and other sensors such as an MR (Magneto Resistive Sensor) sensor as well as an optical pumping atomic magnetometer may be selected in response to the signal of the subject to be measured. The measured value of the magnetic sensor 40 is transmitted to the controller 11.

In the second embodiment, the timing of changing the center value F of the frequency characteristic C of the optical pumping atomic magnetometer 10 is also taken into account the magnetic field signal from the subject to be measured by the magnetic sensor 40. That is, in the second embodiment, the controller 11 transmits a signal that changes the command value to the external coil driver 21 based on both signals received from the stimulating application device 30 and signals received from the magnetic sensor 40. The external coil driver 21 sequentially changes the command value to the external coil 20 in order to change the center value F of the frequency characteristic C in response to a command from the controller 11.

In the second embodiment, a specific timing for changing the center value F of the frequency characteristic C is, for example, when a change occurs in a magnetic field (measured value by the magnetic sensor 40) generated by the stimulation to the subject to be measured is large or small compared to a preset value. The timing may be changed depending on the event to be measured, such as simultaneously with the change or after a predetermined period of time from the change.

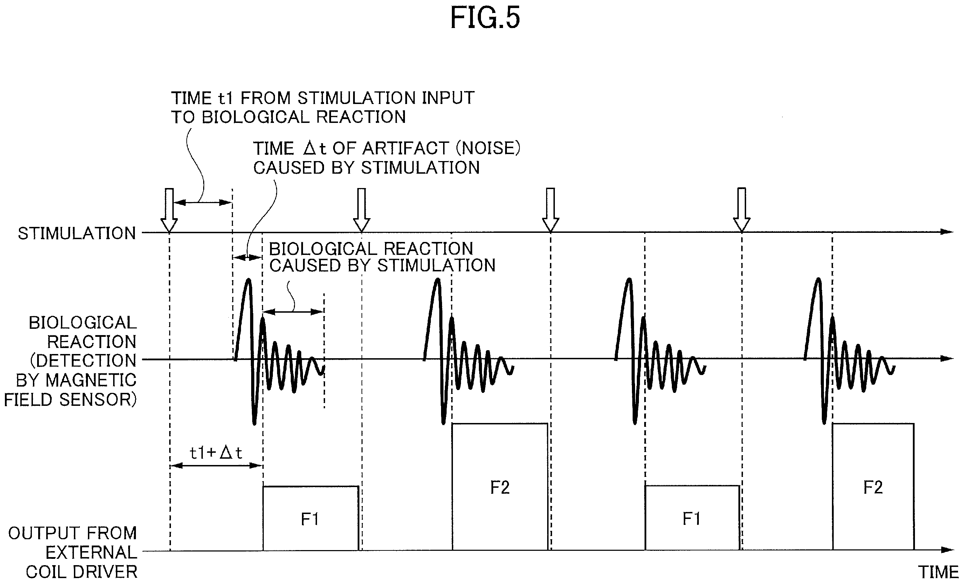

The timing of the change of the center value F according to the second embodiment will be further described with reference to FIG. 5. FIG. 5 is a diagram illustrating an example of frequency characteristic change timing considering the stimulation and magnetic field variation. In the example of FIG. 5, after the stimulation is applied to a subject (a living body) to be measured by the stimulation application device 30, a magnetic field variation (a biological reaction) in response to the stimulation is generated and detected by the magnetic sensor 40, the external coil driver 21 outputs a command value and outputs two predetermined command values alternately. For example, in the first stimulation illustrated in FIG. 5, the command value of the external coil driver 21 corresponding to the center frequency F1 is output, in the next stimulation, the command value of the external coil driver 21 corresponding to the center frequency F2 is output, and in the next stimulation, the command value of the external coil driver 21 corresponding to the center frequency F1 is output. Thus, the measurement is performed while changing the center value F of the frequency characteristic C of the optical pumping atomic magnetometer 10.

In this case, a noise component (an artifact caused by stimulation) that is not required for observation may be generated in the magnetic field signal generated by the stimulation of the subject to be measured.

FIG. 5 illustrates the situation in which a large noise component is generated during a rise of the magnetic field signal, followed by the generation of the magnetic field signal, which is a biological reaction by the stimulation.

In this case, in order to extract the magnetic field signal that is the biological reaction to be observed, it is preferable that a rise noise be detected by the magnetic sensor, and then a command value is output from the external coil driver 21 after a certain period of time so as to exclude the portion of the rise artifact that forms the noise component.

For example, if a variation of the biological reaction is detected after a time t1 has elapsed from the application of the stimulation, the command value is not immediately output from the external coil driver 21, and the command value is output after a time Δt of the artifact has elapsed, that is, after a time t1 + Δt has elapsed from the application of the stimulation.

Unlike the example illustrated in FIG. 5, in the case of an biological reaction in which there is no artifact, the command value can be output from the external coil driver 21 at the same time as the biological reaction from the stimulation input is detected by the magnetic sensor (in the example illustrated in FIG. 5, after a time t1 has elapsed).

In the magnetic measuring system 1A according to the second embodiment, the control device 11 changes the output from the external coil driver 21 and changes the center frequency F of the frequency characteristic C of the optical pumping atomic magnetometer 10 based on the information of the state of the subject to be measured, such as the biological magnetic field, detected by the magnetic sensor 40, and the information of the operation of applying the stimulation to the subject to be measured by the stimulation application device 30. With this structure, the frequency characteristic C of the optical pumping atomic magnetometer 10 can be changed at a more appropriate timing, taking into account both stimulation and magnetic field variation, thereby enabling a high precision magnetic measurement. In addition, it is possible to measure the stimulation applied to the subject to be measured in relation to the biological response of the subject to be measured.

### [Third Embodiment]

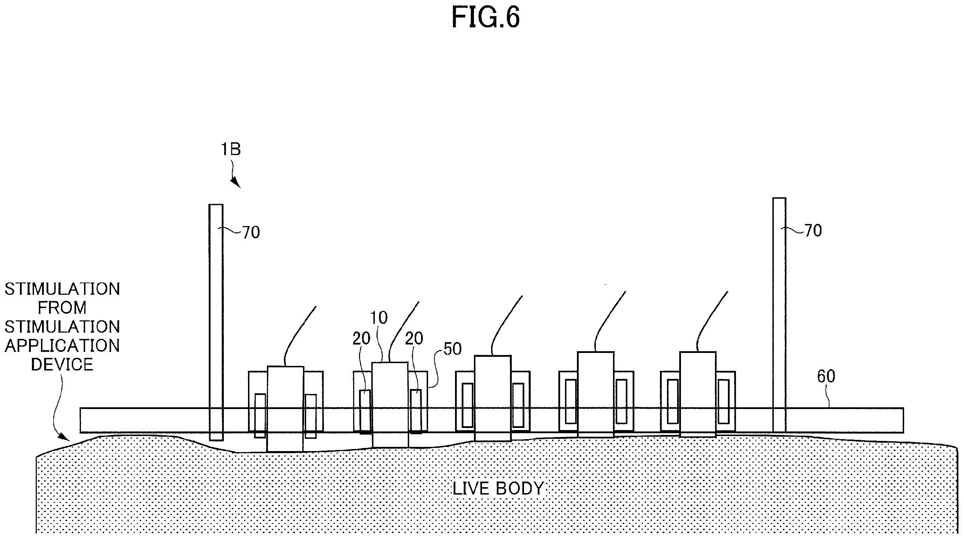

A third embodiment will be described with reference to FIGS. 6 to 14. The magnetic measuring system 1 according to the third embodiment is an example of a structure in which the optical pumping atomic magnetometer 10 is used for the living body.

FIG. 6 is a schematic diagram illustrating a schematic structure of the magnetic measuring system 1B according to the third embodiment. In FIG. 6, the subject to be measured and the magnetic measuring system 1B according to the present embodiment are viewed in cross-section.

As illustrated in FIG. 6, in the third embodiment, a pair of optical pumping atomic magnetometers 10 and a pair of external coils 20 are mounted to the sensor fixing member 60 via the cylindrical member 50, and the sensor fixing member 60 is positioned on a surface of the living body as the subject to be detected. The cable from the optical pumping atomic magnetometer 10 is connected to the controller 11 (see FIG. 1, etc.), and the external coil 20 is connected to the external coil driver 21 (see FIG. 1, etc.). As the stimulation application device 30, an electrical stimulation application device is used here.

Further, in the magnetic measuring system 1B, an environmental magnetic field reducing coil 70 is disposed for reducing the environmental magnetic field. The environmental magnetic field reducing coil 70 is connected to the external coil driver 21 or equivalent a drive unit equivalent to the external coil driver 21. In the magnetic measuring system 1B, the pair of optical pumping atomic magnetometers 10 and the pair of external coils 20 can be set to have a quantity that is necessary for measurement, and is not limited to five pairs illustrated in FIG. 6. The external coil driver 21 may be built into the optical pumping atomic magnetometer 10.

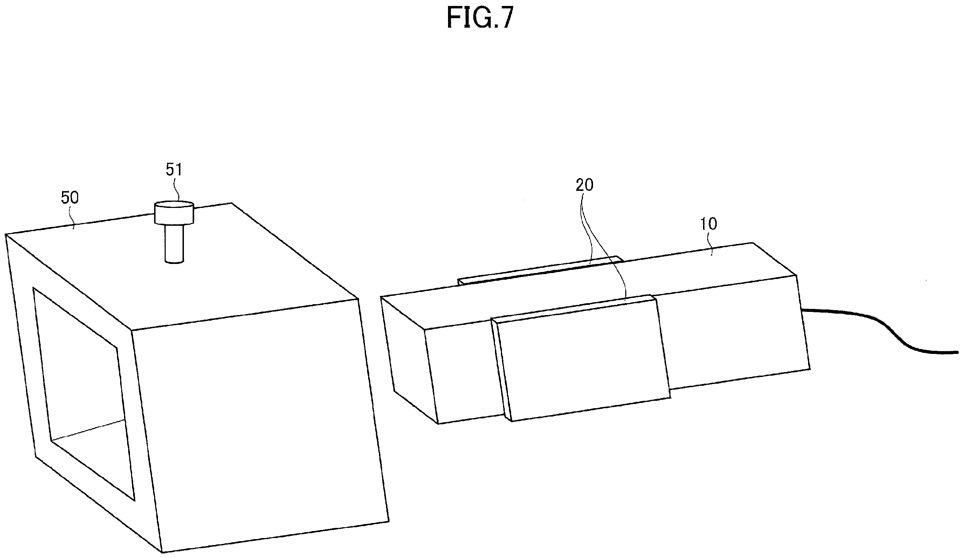

FIG. 7 is a perspective view illustrating an enlarged view of the OPM 10 and the cylindrical member 50 illustrated in FIG. 6. As illustrated in FIG. 7, the cylindrical member 50 is threaded with a sensor fixing screw 51 for securing the optical pumping atomic magnetometer 10, and the sensor fixing screw 51 is used to secure the optical pumping atomic magnetometer 10 in place inserted into the cylindrical member 50.

The cylindrical member 50 is made of a material having a magnetic field shielding effect such that the magnetic field generated by the external coil 20 does not affect the magnetic field detection of another set of an optical pumping atomic magnetometer 10.

In the example of FIG. 6, the cylindrical member 50 is fixed to the sensor fixing member 60 by a screw or the like. However, the cylindrical member 50 may be integrated with the sensor fixing member 60.

In order to prevent the distance between the optical pumping atomic magnetometer 10 and the surface of the living body from being different from each set of an optical pumping atomic magnetometer 10, a mechanism may be provided to push the optical pumping atomic magnetometer 10 in such a way that the position for fixing the optical pumping atomic magnetometer 10 with respect to the cylindrical member 50 can be changed.

Further, a fitting structure other than the screw 51 may be used as a means for fixing the optical pumping atomic magnetometer 10 to the cylindrical member 50. Said differently, a mechanism such that the position of the optical pumping atomic magnetometer 10 is changed with respect to the cylindrical member 50 may be employed.

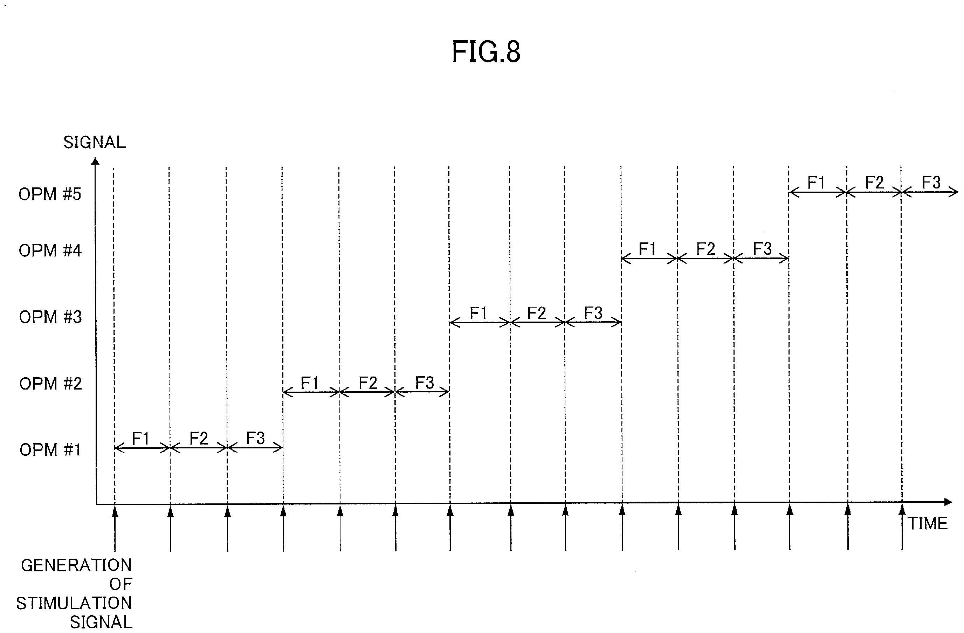

Referring to FIG. 8, an operation of the magnetic measuring system 1B according to the third embodiment will be described. FIG. 8 is a diagram illustrating a first pattern of applying a current to multiple OPMS 10.

As described with reference to FIG. 3, the optical pumping atomic magnetometer 10 in accordance with the present embodiment can move the center frequency F of the frequency characteristic C by adjusting the magnetic field of the external coil 20.
As illustrated in FIG. 3, by moving the center frequency of the frequency characteristic from F1 to F2 and from F2 to F3, an apparent frequency band B of the single optical pumping atomic magnetometer 10 can be expanded.

Here, it is assumed that by changing the center frequency of the frequency characteristic of the optical pumping atomic magnetometer 10 to three values of F1, F2, and F3, the frequency band of the magnetic field signal generated from the living body can be covered. FIG. 8 illustrates an example of a center frequency changing pattern (a current application pattern) of each sensor in a case where a set of five optical pumping atomic magnetometers 10 and the external coils 20 illustrated in FIG. 6.
In FIG. 8, the five sets of optical pumping atomic magnetometers 10 are represented as OPMS #1 to #5, respectively.

When observing a response of the living body when a stimulation signal (an electrical stimulation) is applied to the living body, the stimulation signal is first detected at the center value F1 of the frequency characteristic of OPM #1 immediately after the stimulation signal is generated, then the center value is detected at F2 immediately after the next stimulation signal is generated, and the center value is then moved to F3 immediately after the next stimulation signal is generated. Thereafter, the detection of OPM #2 moves the center value of the frequency characteristic from F1 to F3 according to the generation of the stimulation signal, and then operates in the same manner as OPM #3, OPM #4, and OPM #5. At this time, the environmental magnetic field is reduced by a signal from the external coil driver 21 so that the environmental magnetic field is less than a magnetic field detectable by the optical pumping atomic magnetometer 10 by the environmental magnetic field reducing coil 70 (see FIG. 5). The frequency change pattern illustrated in FIG. 8 is a process in which the center frequency of the frequency characteristic C is changed from a smaller to a larger one at each application of the stimulation in any single optical pumping atomic magnetometer 10, and this process is sequentially performed by all the optical pumping atomic magnetometer 10 (OPM #1 to OPM #5) in the system.

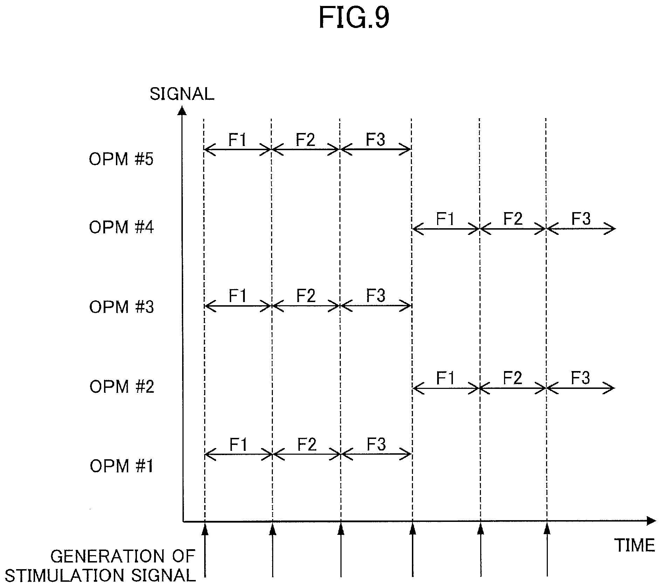

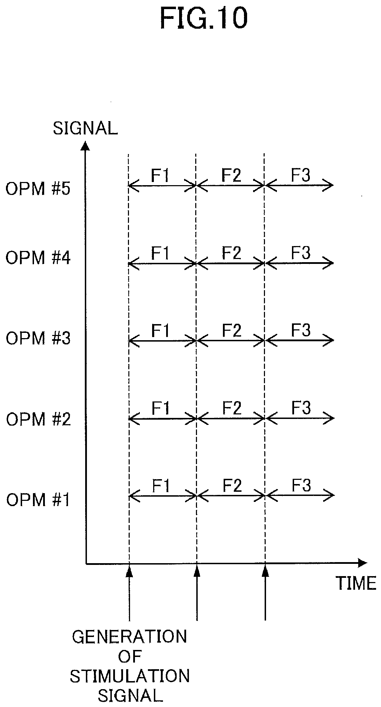

An alternative embodiment of such a current application pattern will be described with reference to FIGS. 9 and 10. FIG. 9 is a diagram illustrating a second pattern of applying a current to the multiple OPMS 10. Considered next is a case where the optical pumping atomic magnetometer 10 is arranged in the order of OPM #1, OPM #2, OPM #3, OPM #4, and OPM #5, and the external coils 20, if they are not adjacent to each other, are operated simultaneously without affecting the detection of the magnetic field. In this case, as illustrated in FIG. 9, the center values of the frequency characteristics of the three non-adjacent OPMS #1, #3, and #5 are first changed in the order of F1, F2, and F3 every time the stimulation signal is generated. Next, in the remaining two OPM #2 and OPM #4 that are not adjacent to each other, the center value of the frequency characteristic is changed in the order F1, F2, and F3 every time the stimulation signal is generated.

FIG. 10 is a diagram illustrating a third pattern of the current application to the multiple OPMS 10. Considered next is a case where the optical pumping atomic magnetometer 10 is arranged in the order of OPM #1, OPM #2, OPM #3, OPM #4, and OPM #5, and the external coil 20 is not affected even if the external coil 20 operates simultaneously with each other. Such a situation may be, for example, a case where the interval between the sensors is sufficiently long. In this case, as illustrated in FIG. 10, in all OPMS #1 to #5, the center value of the frequency characteristic is changed simultaneously in the order of F1, F2, and F3 every time the stimulation signal is generated.

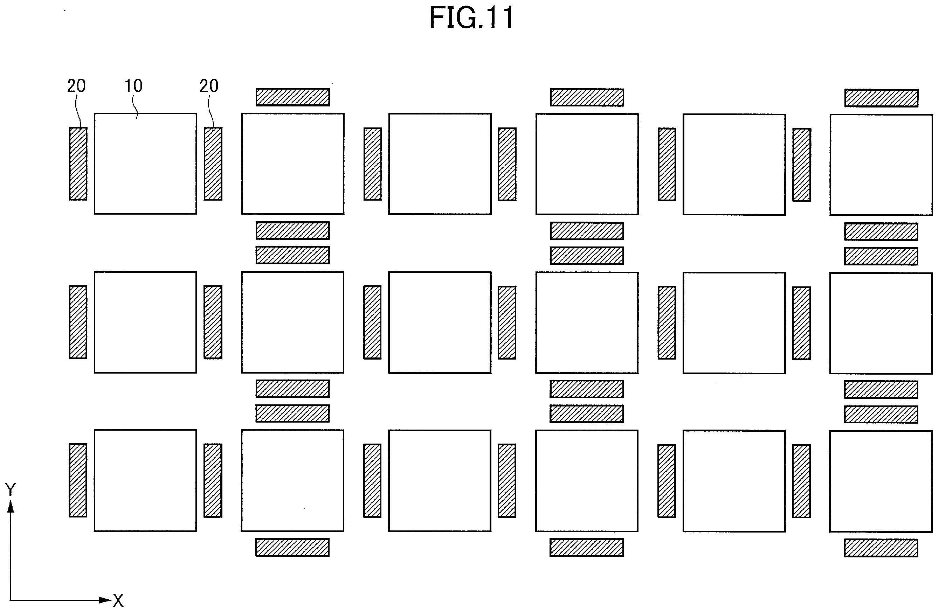

Next, an arrangement pattern of the multiple optical pumping atomic magnetometer 10 will be described with reference to FIGS. 11 to 14.

FIG. 11 is a diagram illustrating a first arrangement pattern of the multiple OPMS 10.
In FIG. 11, sets of each optical pumping atomic magnetometer 10 and each pair of external coils 20 are arranged, in which 6 sets are arranged in an X direction on the X-Y plane and 3 sets are arranged in a Y direction on the X-Y plane, totally 6x3=18 sets are arranged on an X-Y plane. In the example of FIG. 11, each direction of arranging the pair of external coils sandwiching the optical pumping atomic magnetometer 10 is the same along the Y-direction but is alternately changed along the X-direction. Said differently, the directions of arranging the pair of external coils 20 (facing directions of the pair of external coils 20) are the same X direction in a certain group formed by the optical pumping atomic magnetometers 10 arranged along the Y-direction, and the directions of arranging the pair of external coils 20 are the same Y direction in a group adjacent in the X-direction to the certain group.

The first arrangement pattern illustrated in FIG. 11 is determined so that an influence of the magnetic field generated by the external coils 20 for one of the optical pumping atomic magnetometers 10 to the direction causing magnetic field sensitivity emanated from the adjacent one of the optical pumping atomic magnetometers 10 in use of the structure that the magnetic field application direction applied by the external coil 20 is only one when the center value F of the frequency characteristic C of the optical pumping atomic magnetometer 10 is changed by the external coil 20. Even when a material having a magnetic field shielding effect is utilized on the cylindrical member 50, such an arrangement allows a detection of the magnetic field without further influence from the adjacent one of the optical pumping atomic magnetometers 10.

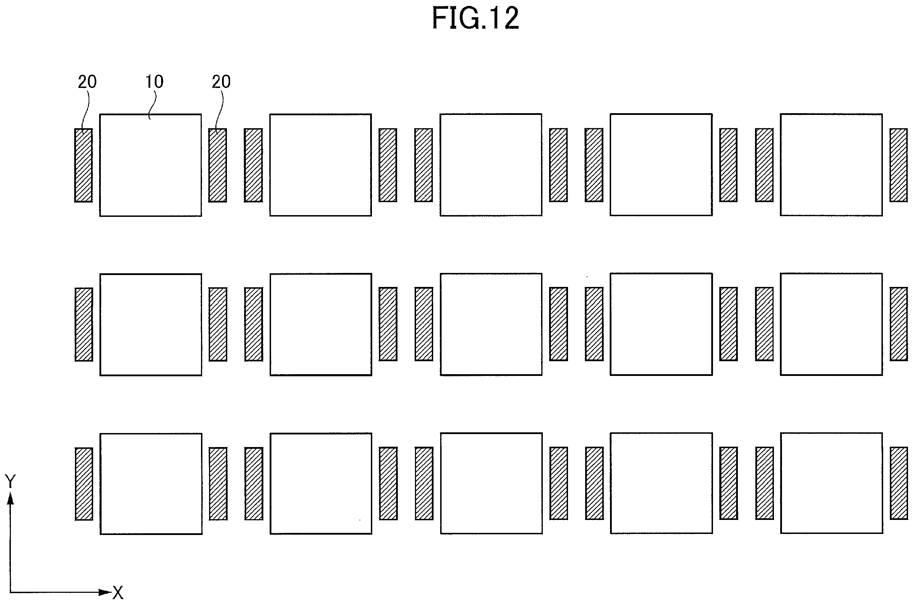

FIG. 12 is a diagram illustrating a second arrangement pattern of the multiple OPMS 10. In an example of FIG. 12, a total of 5x3=15 sets of the pair of an optical pumping atomic magnetometer 10 and the pair of external coils 20 are arranged on the X-Y plane, namely, 5 sets in the X-direction and 3 sets in the Y-direction. In the example of FIG. 12, the facing direction of each pair of external coils 20 is all unified in the X-direction.

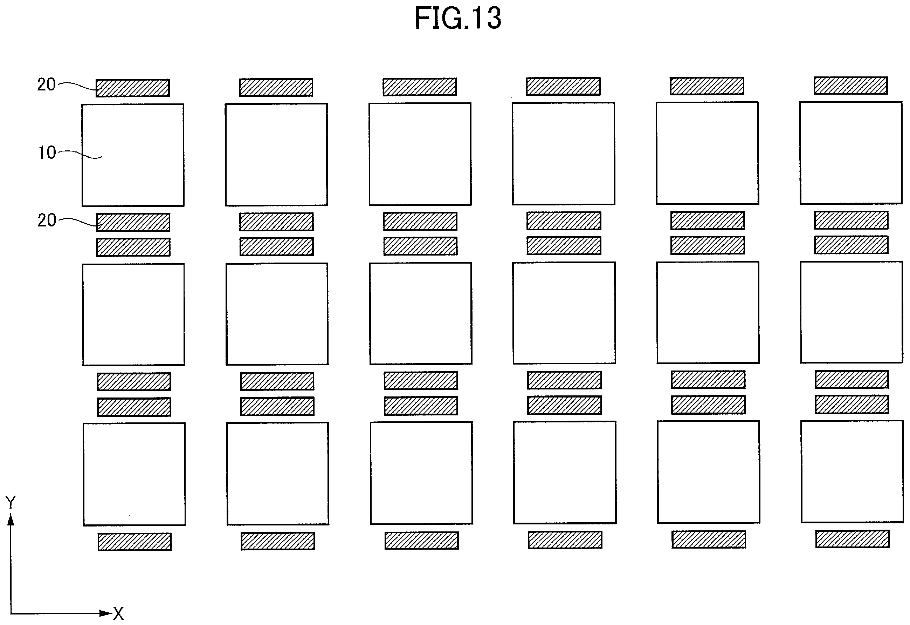

FIG. 13 is a diagram illustrating a third arrangement pattern of the multiple OPMS 10. In an example of FIG. 13 in a manner similar to FIG. 12, a total of 5x3=15 sets of the optical pumping atomic magnetometer 10 and the pair of the external coils 20 are arranged on the X-Y plane, namely, the facing directions of the pair of the external coils 20 are unified in the Y-direction.

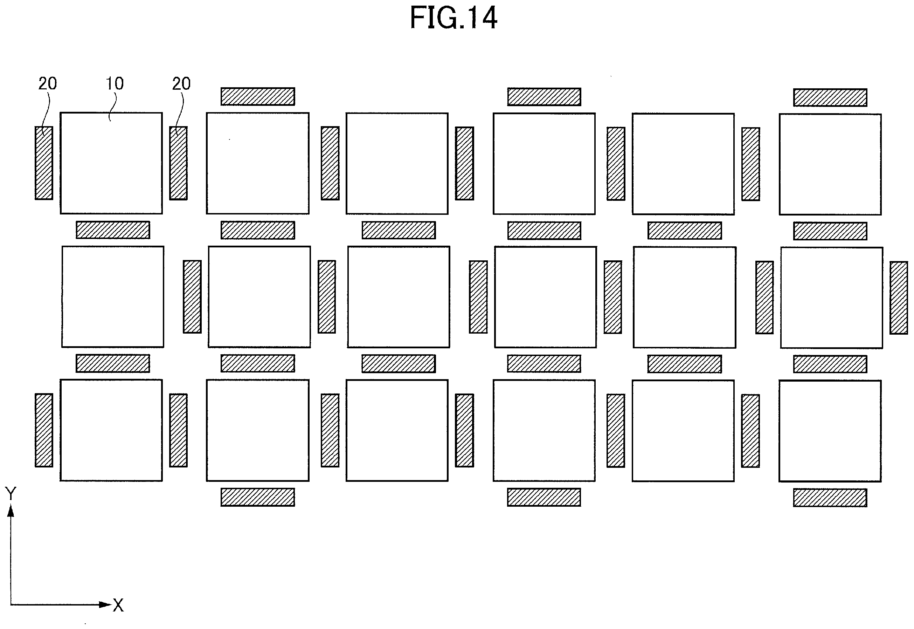

FIG. 14 is a diagram illustrating a fourth arrangement pattern of the multiple OPMS 10. In the example of FIG. 14 in a manner similar to FIG. 11, a total of 6x3=18 sets of the optical pumping atomic magnetometer 10 and the pair of the external coils 20 are arranged on the X-Y plane, namely, the facing directions of the pair of the external coils 20 are different with respect to both of the X and Y directions.

In any one of the first to fourth arrangement patterns illustrated in FIGS. 11 to 14, when measuring the magnetic field from the living body, it is possible to operate without causing crosstalk from the adjacent optical pumping atomic magnetometer 10. Further, the multiple sets including the pairs of the optical pumping atomic magnetometer 10 and the pairs of the external coils 20 are arranged like the first to fourth arrangement patterns, so that magnetic field measurement can be accurately performed even in a case where the measurement area of the measurement target is a large area that is several times to several tens of times larger than a measurable area which can be measured by a single OPM 10.

### [OPM Calibration]

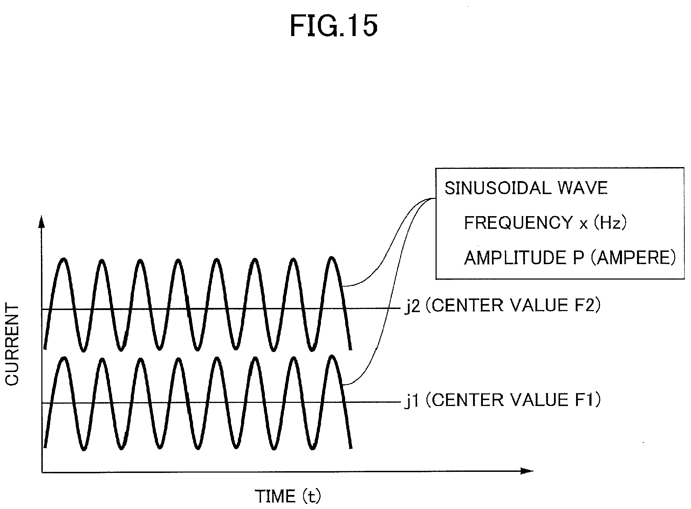

The optical pumping atomic magnetometer 10 varies in characteristics due to manufacturing errors and so-called individual difference.
Therefore, when the single or multiple optical pumping atomic magnetometers 10 are used in the system, calibration is required to eliminate signal variation due to the individual difference in frequency characteristic C or the like.
Calibration of the optical pumping atomic magnetometer 10 is also required for the magnetic measuring systems 1, 1A, and 1B according to the first to third embodiments described above.
Referring to FIGS. 15 to 20, a calibration method of the optical pumping atomic magnetometer 10 is described in accordance with the present embodiment.

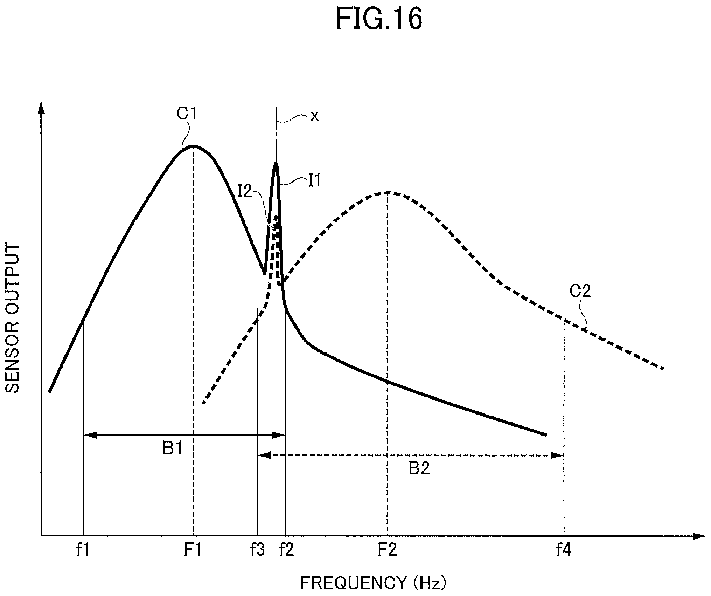

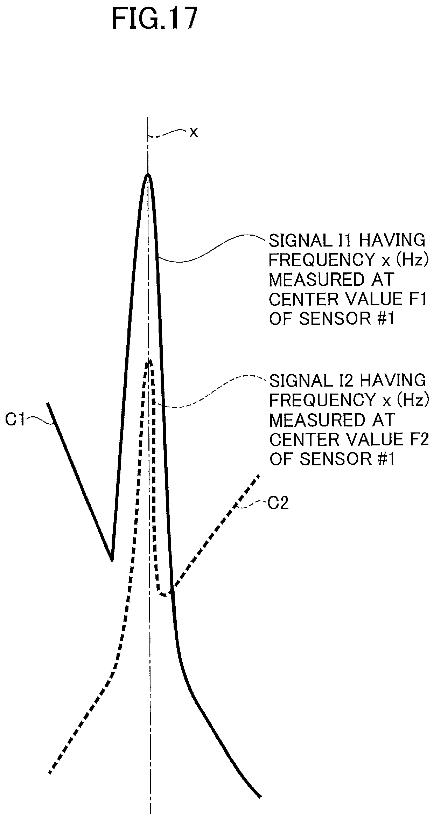

Referring first to FIGS. 15 to 17, a calibration procedure between multiple frequency characteristics C1 and C2 in the single optical pumping atomic magnetometer 10 will be described. FIG. 15 is a diagram illustrating the waveform of the applied current during calibration of the single OPM 10. FIG. 16 is a diagram illustrating the frequency characteristic of the single OPM when the current illustrated in FIG. 15 is applied. FIG. 17 is an enlarged view of the vicinity of the magnetic field signal of FIG. 16.

In FIG. 16, the frequency of an intersection between the right side (a high frequency side) of the frequency characteristic C1 of the center frequency F1 and the left side (a low frequency side) of the frequency characteristic C2 of the center frequency F2 is denoted by x (Hz).

An external coil driver 21 generates an alternating current of a sinusoidal wave having a frequency of x (Hz) and an amplitude of P (amperes).
As illustrated in FIG. 15, the sinusoidal wave is superposed on the DC bias current j1 (corresponding to the center value F1 of the frequency characteristic C1) and the bias current j2 (corresponding to the center value F2 of the frequency characteristic C2) previously applied to the external coil 20 (or offsets of j1 and j2 are added to the sinusoidal wave) .

The frequency characteristics C1 and C2 when the current illustrated in FIG. 15 is applied are illustrated in FIG. 16. When the current of the waveform illustrated in FIG. 15 is applied to the external coil 20, an alternating magnetic field of frequency x (Hz) is generated. When this is measured by the optical pumping atomic magnetometer 10, as illustrated in FIG. 16, in addition to the frequency characteristics C1 and C2 caused by the bias DC currents j1 and j2, the magnetic field signals I1 and I2 with peaks at the position of frequency x (Hz) are generated. The magnetic field signal I1 is the output when measured with frequency characteristic C1, and the magnetic field signal I2 is the output when measured with frequency characteristic C2.
As illustrated in FIG. 17, the peak values of the magnetic field signal I1 and the magnetic field signal I2 are generally different.
Such differences are caused by differences in the frequency characteristics C1 and C2 of the sensors.
However, since the sinusoidal waves superposed on each of the bias currents j1 and j2 are the same, the two outputs I1 and I2 should be the same.

In this embodiment, the difference in the peak value between the magnetic field signal I1 and the magnetic field signal I2 is adjusted by an amplifier gain or the like. As illustrated in FIGS. 16 and 17, the magnetic field signal I1 of the frequency characteristic C1 and the magnetic field signal I2 of the frequency characteristic C2 have a relation of I1>I2, and when it is desired to align the peak values of I1 and I2, for example, the gain S is set to S=I1/I2, and the gain S is multiplied by the output from the OPM 10 when the frequency characteristic C2.

### (When the frequency characteristic C1 is used as a reference)

Therefore, the frequency characteristic C2 and the magnetic field signal I2 are corrected so that the frequency characteristic C2 and the magnetic field signal I2 are shifted in the increasing direction. As a result, the magnetic field signal I2 is corrected so that the magnetic field signal I1 is equal to the magnetic field signal I2. In this way, by correcting the output of each frequency characteristic C1 and C2, the effect of the difference in the frequency characteristic C1 and C2 can be reduced, and the measurement system can be uniformized throughout the frequency band B in which the single OPM 10 can be measured.

Incidentally, the calibration method is the same even when the number of frequency characteristics that can be set by a single OPM 10 is three or more (N≧3). Alternatively, instead of adjusting the applied current as described above, the applied current may be software-adjusted on the measured data. The alternating current waves superposed on the bias signals j1 and j2 illustrated in FIG. 15 are not limited to sinusoidal waves. For example, the alternating current waves may be triangular waves or square waves.

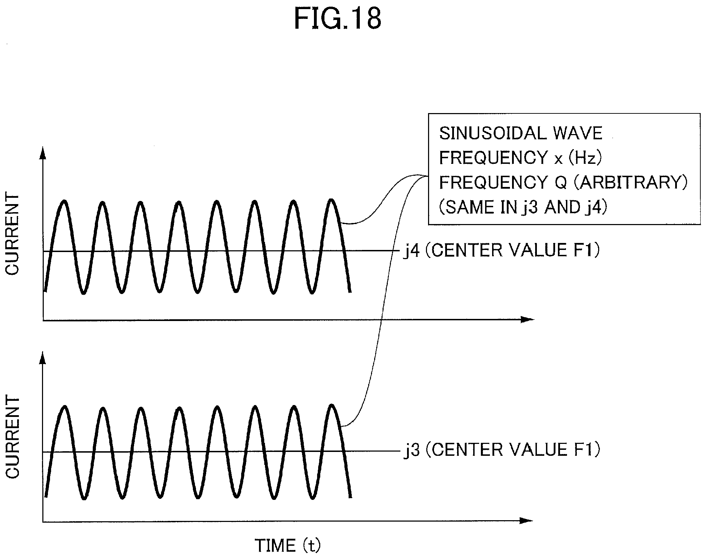

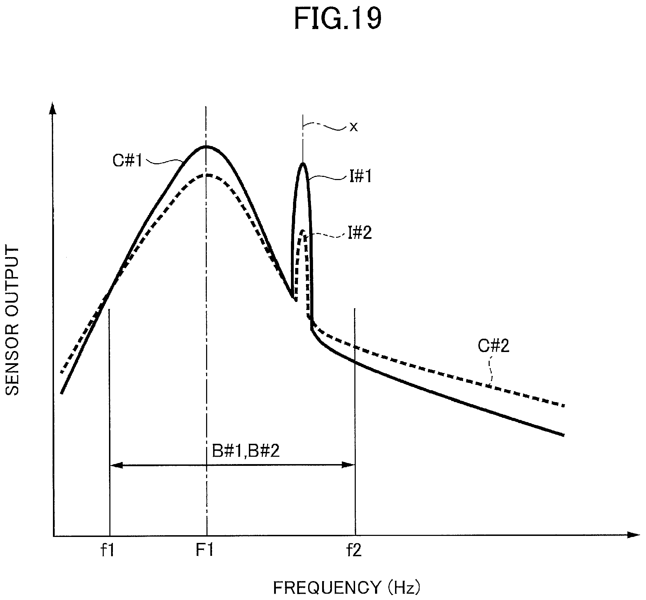

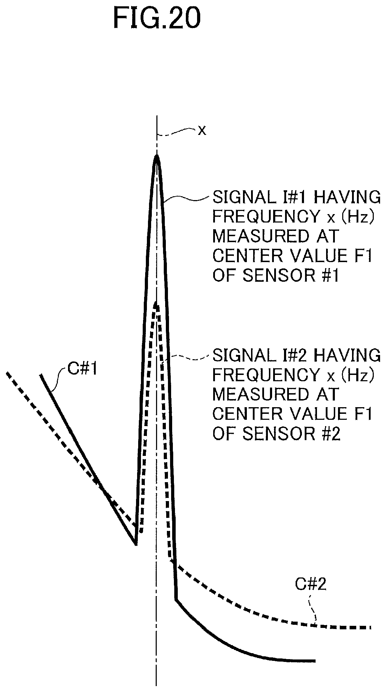

Referring now to FIGS. 18 to 20, a calibration procedure between multiple different optical pumping atomic magnetometers 10 will be described. FIG. 18 is a diagram illustrating the waveform of the applied current during calibration of the multiple OPMS 10. FIG. 19 is a diagram illustrating the frequency characteristics of the multiple OPMS when the current illustrated in FIG. 18 is applied. FIG. 20 is an enlarged view of the vicinity of the magnetic field signal of FIG. 19. Described hereinafter is the calibration between two optical pumping atomic magnetometers 10, one of which is represented by OPM#1 and the other by OPM#2. In this case, as illustrated in FIG. 19, the frequency characteristic C#1 of the OPM#1 and the frequency characteristic C#2 of the OPM #2 are calibrated when the same center frequency F1 is taken.

In FIG. 19, an arbitrary frequency within the bandwidth B#1 of the frequency characteristic C#1 of the OPM#1 and within the bandwidth B#2 of the frequency characteristic C#2 of the OPM#2 is denoted by x (Hz).

An external coil driver 21 generates a sinusoidal wave with a frequency of x (Hz) and an amplitude of Q (amperes). As illustrated in FIG. 18, the sinusoidal wave is superposed on the DC bias current j3 (corresponding to the center value F1 of the frequency characteristic C#1 of OPM#1) and the bias current j4 (corresponding to the center value F1 of the frequency characteristic C#2 of OPM#2) previously applied to the external coil 20 (or offsets of j3 and j4 are added to the sinusoidal wave). Because the bias currents j3 and j4 are applied to realize the frequency characteristic of the same center frequency F1, the same value is obtained.

FIG. 19 illustrates the frequency characteristics C#1 and C#2 when the current illustrated in FIG. 18 is applied. When the current of the waveform illustrated in FIG. 18 is applied to the external coil 20, an alternating magnetic field of frequency x (Hz) is generated. When this is measured by the optical pumping atomic magnetometer 10 (OPM#1, OPM#2), as illustrated in FIG. 19, in addition to the frequency characteristics C#1 and C#2 caused by the bias DC currents j3 and j4, the magnetic field signals I#1 and I#2 having a peak at the position of frequency x (Hz) are generated. The magnetic field signal I#1 is an output when measured by OPM#1, and the magnetic field signal I#2 is an output when measured by OPM#2. As illustrated in FIG. 20, the peak values of the magnetic field signals I#1 and I#2 are generally different. Such differences are caused by individual differences in the sensors. However, since the sinusoidal wave that is superposed on the respective bias currents j3 and j4 and is input is the same in both OPM#1 and OPM#2, the two outputs I#1 and I#2 should essentially be the same.

Therefore, in this embodiment, the difference in the peak value between the magnetic field signal I#1 and the magnetic field signal I#2 is adjusted by an amplifier gain or the like. As illustrated in FIGS. 19 and 20, the magnetic field signal I#1 of OPM#1 and the magnetic field signal I#2 of OPM#2 are related to I#1>I#2, and when it is desired to align the peak values of I#1 and I#2, for example, the gain S is multiplied by OPM#2 with S=I#1/I#2.

### (When OPM #1 is used as the reference.)

Accordingly, the frequency characteristic C#2 and the magnetic field signal I#2 are corrected so that the frequency characteristic C#2 is shifted in the increasing direction, and as a result, the magnetic field signal I#2 is corrected to be equal to the magnetic field signal I#1. By correcting the output of each OPM 10 in this manner, the influence of the individual differences in the sensors can be reduced, and the measurement system of the multiple OPMS 10 can be uniformized throughout the frequency band B over which the magnetic measuring systems 1, 1A, and 1B can be measured.

Incidentally, the same calibration method is used when the number of OPM10 is three or more (N≧3). Alternatively, instead of adjusting the applied current as described above, the applied current may be software-adjusted on the measured data. The alternating current waves superposed on the bias signals j3 and j4 illustrated in FIG. 18 are not limited to sinusoidal waves. For example, the alternating current waves may be triangular waves or square waves.

It is preferable that the dimensions of the OPM 10 be about 10 to several tens of millimeters on each side of the cross-sectional shape when the longitudinal cross-section is rectangular as illustrated in FIG. 7. The distance between the OPMS 10 when the multiple OPMS 10 is arranged is preferably about 10 to 30 mm. The frequency band B of the OPM 10 is preferably from a few kHz to several tens of kHz.

Hereinafter, the fourth embodiment will be described with reference to the accompanying drawings.
In order to facilitate the understanding of the description, the same elements in each drawing are, as far as possible, designated by the same reference numerals, and the overlapping description is omitted.

In the following description, the X-direction, Y-direction, and z-direction are orthogonal to one another. The X-direction is facing directions of the pair of external coils 20 provided in the single optical pumping atomic magnetometer 10. The z-direction is the direction of extending the optical pumping atomic magnetometer 10.

In the following description, the optical pumping atomic magnetometer 10 may be referred to as "OPM".

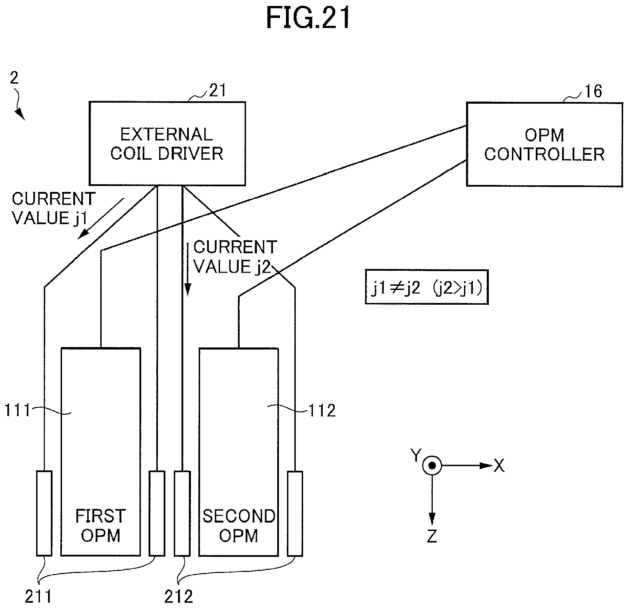

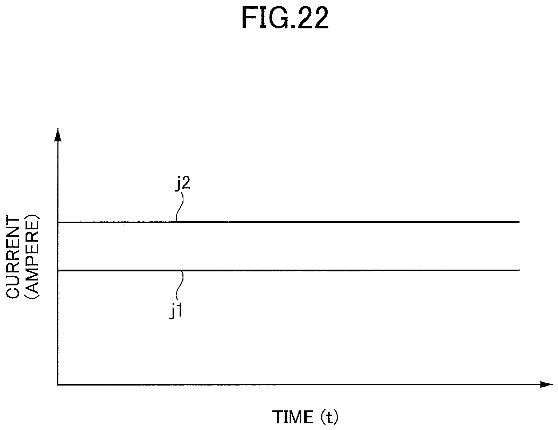

FIG. 21 is a diagram illustrating a schematic structure of the magnetic measuring device 2 according to the fourth embodiment. FIG. 21 illustrates a case (N=2) where each of two optical pumping atomic magnetometers 10 is provided with the pair of external coils 20. The pair of external coils 20 are arranged to sandwich the OPM 10. FIG. 21 is viewed from the side. When viewed from another side, the shape of each of the pair of external coils 20 is circular and polygonal (see FIGS. 22 to 25).

In other words, FIG. 21 is the structure of the smallest unit of the magnetic measuring device 2 according to the fourth embodiment and has two OPMS 10, namely, the first OPM 111 and the second OPM 112. The first OPM 111 and the second OPM 112 are arranged along the X-direction. A pair of first external coils 211 are disposed opposite to each other in the X-direction of the first OPM 111. Similarly, on both sides of the second OPM 112 in the X-direction, a pair of second external coils 212 is arranged so as to face each other in the X-direction.

The numbers of the OPMS or the external coils provided in the magnetic measuring device 2 is not limited to two, and the numbers of the multiple OPMS or external coils may be any. In the following description, the multiple OPMS of the magnetic measuring device 2, namely the first OPM 111 or the second OPM 112, may be collectively referred to as an "OPM 10". Similarly, the multiple external coils provided in the magnetic measuring device 2 may be collectively referred to as an "external coil 20" as in the case of the first external coil 211 or the second external coil 212.

As illustrated in FIG. 21, the external coil 20 is connected to the external coil driver 21. The external coil driver 21 can cause a current having a desired waveform. For example, the external coil driver 21 a function generator. FIG. 22 is a diagram illustrating an example of an application pattern of applying a current to an external coil. The axis of abscissa of FIG. 22 indicates a time (t) and the axis of ordinate indicates the current value (ampere). As illustrated in FIG. 22, the external coil driver 21 applies the DC current to the external coils 20. At this time, a bias current j1 applied to the first external coil 211 is different from the current value j2 applied to the second external coil 212. In this example, j2>j1. When a DC current is applied to the external coil 20, a static magnetic field is generated from the external coil 20 in response to the current value. In FIG. 21, the static magnetic field is generated in the X-direction. The words of "positive and negative" depends on the direction in which the current is applied. In FIG. 21, the direction of the current is indicated by an arrow, but this direction may be opposite to the arrow.
This is possible by reversing the polarity of the external coil driver 21.

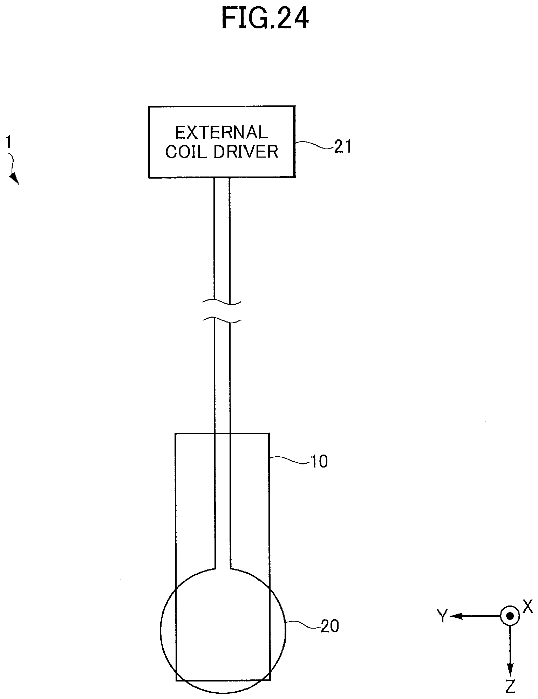

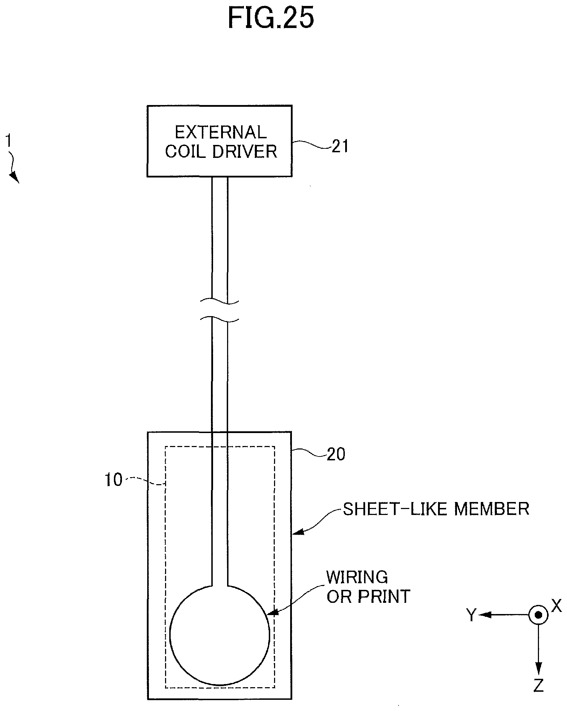

FIGS. 22 to 25 illustrate an example of the shape of the external coil 20. The external coil 20 may have a polygonal shape, for example, a square shape, as illustrated in FIG. 22, or a circular shape, as illustrated in FIG. 24, when viewed from the X-direction different from that of FIG. 21 by 90 degrees. Further, as illustrated in FIG. 25, the wiring may be disposed on the sheet-like member.
This is made by attaching wires or printing. Also, although the number of turns of the coil is one in this figure, it may be multiple.

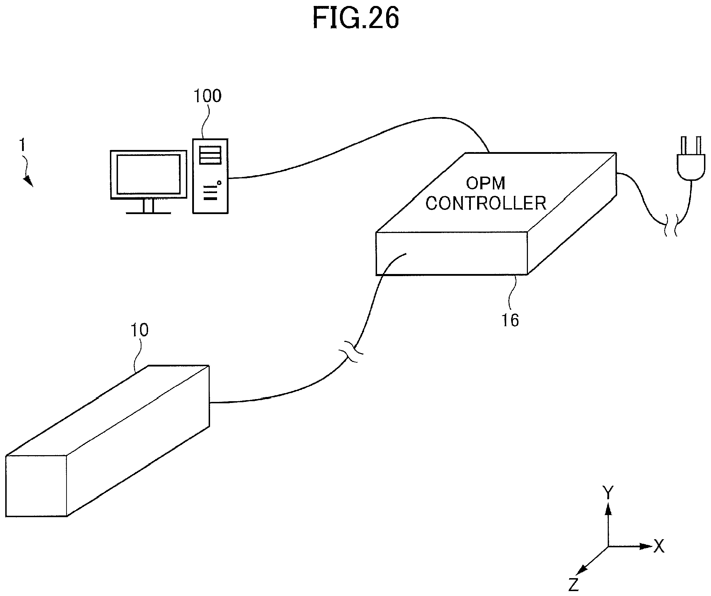

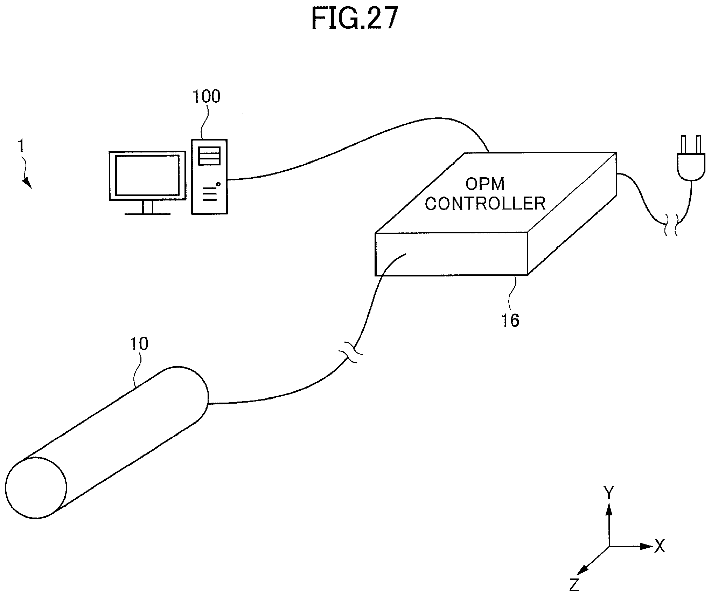

As illustrated in FIG. 21, the magnetic detecting unit (the sensor head) of the OPM 10 is connected to an OPM controller 16. FIGS. 26 and 27 are perspective views schematically illustrating the structure of the OPM 10. The magnetic detecting unit (the sensor head) of the OPM 10 may have a shape such as a prismatic shape as illustrated in FIG. 26 or a cylindrical shape as illustrated in FIG. 27. The OPM controller 16 processes a control of the laser light source for pump light and the laser light source for probe light, a control of a photodetector, overheating of the gas cell encapsulated with the alkali metal vapor, a temperature control, a control of the OPM 10 from the computer 100, a transfer of the data measured by the OPM 10 to the computer 100, and the like. The OPM controller 16 mainly includes an electrical and electronic circuit.

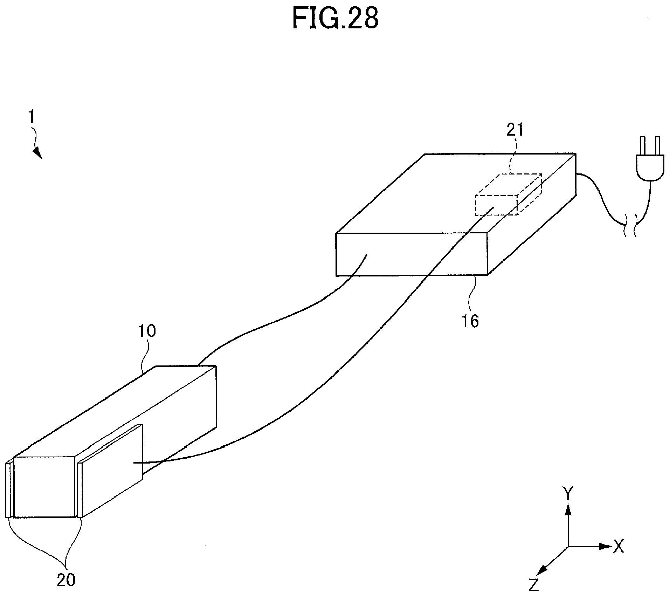

FIG. 28 is a perspective view illustrating an example of a structure of the magnetic measuring device 2. As illustrated in FIG. 28, the external coil driver 21 may be provided inside the OPM controller 16.

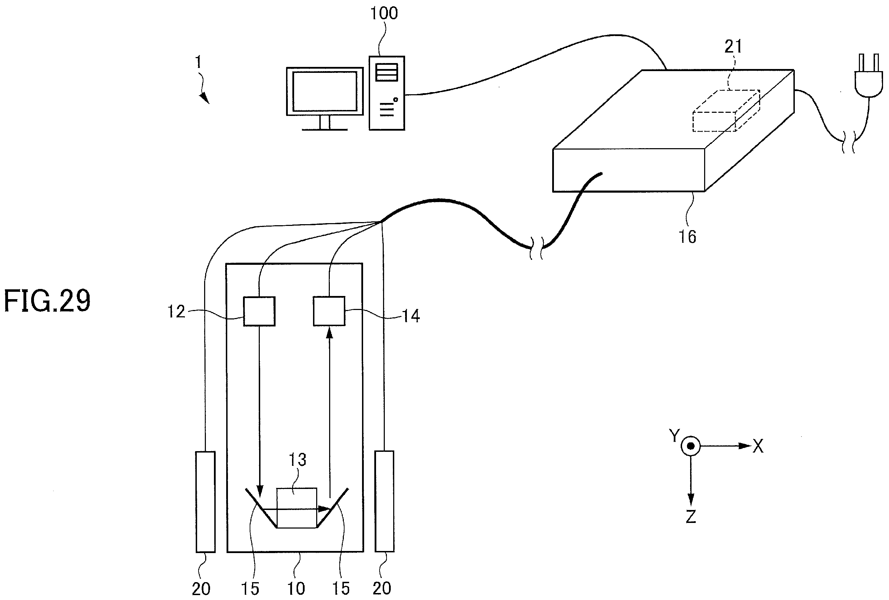

FIG. 29 is a diagram illustrating an example of an internal structure of an optical pumping atomic magnetometer 10. As illustrated in FIG. 29, the optical pumping atomic magnetometer 10 includes a pair of mirrors (or a pair of prisms) 15 that fold an optical path on both sides between the pump light source (laser) 12 for optical pumping, the gas cell 13, the photodetector 14, and the gas cell 13. The structure illustrated in FIG. 29 is one in which the pump light also serves as a probe light. Unlike the structure illustrated in FIG. 29, the probe light may be independent. In this case, the probe light is positioned perpendicular to the pump light.

The gas cell 13 contains a vapor of alkali metal atoms. Alkali atomic species include potassium K, rubidium Rb, and cesium Cs. Other buffer gases include helium He and nitrogen N. A heater is also provided around the gas cell 13 to heat the gas cell 13. The heater uses a resistor, but may alternatively be heated using an infrared laser. The arrangement of the external coil 20 is such that the magnetic field generated by the external coil 20 is parallel to the direction in which the pump light passes through the gas cell 13 (in FIG. 29, X direction).

As illustrated in FIG. 21, a case where the number of the optical pumping atomic magnetometers 10 each provided with the external coils 20 is two. As illustrated in FIG. 22, the current applied to the first external coil 211 is less (j2 > j1) than the current applied to the second external coil 212. This applied current j1, j2 generates a magnetic field from the external coils 211, 212, and a biasing magnetic field is applied to the gas cell 13 inside the first OPM 111 and the second OPM 112. The sensor outputs of each OPM 111, 112 are responsive to this bias magnetic field.

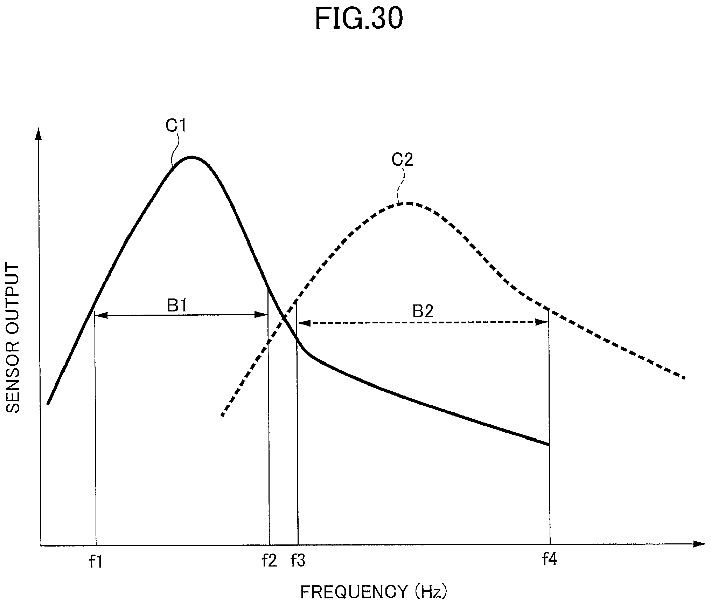

FIG. 30 is a diagram illustrating the frequency characteristics C1 and C2 of the outputs from the first OPM 111 and the second OPM 112 according to the fourth embodiment (the frequency characteristics C1 and C2 may be collectively denoted by a symbol "C" below). The axis of abscissa of FIG. 30 represents a frequency and the axis of ordinate represents a sensor output. As illustrated in FIG. 30, the frequency characteristic C of the output from the OPM 10 is angle-shaped in which the peak position is determined in accordance with a bias magnetic field. As described above, because the bias currents j1 and j2 respectively applied to the first external coil 211 and the second external coil 212 are different, as illustrated in FIG. 30, the peak positions of the angle are different between the frequency characteristic C1 of the output from the first OPM 111 and the frequency characteristic C2 of the output from the second OPM 112. Because the bias current j2 is larger than j1, the frequency characteristic C2 of the second OPM 112 has a peak position on a highfrequency side compared to the characteristic C1 of the first OPM 111.

The measurable frequency band B in this frequency characteristic C is defined, for example, by full width at half maximum. In FIG. 30, the frequency band B1 of the first OPM 111 is defined by f1 (Hz) to f2 (Hz), and the frequency band B2 of the second OPM 112 is defined by f3 (Hz) to f4 (Hz). These frequency bands B are determined, for example, by the current value applied to the external coil 20. When the current value is changed, the frequency band B shifts. The higher the current value, to the higher frequency side the frequency band shifts.

In the first OPM 111 only, the frequency band B1 has only f1 to f2. However, in the fourth embodiment, the frequency band B2 of the second OPM 112 can be used together because of the structure using the two OPMS 111 and 112. Accordingly, the magnetic measuring device 2 is capable of expanding the measurable frequency band B so as to be f1 to f4.

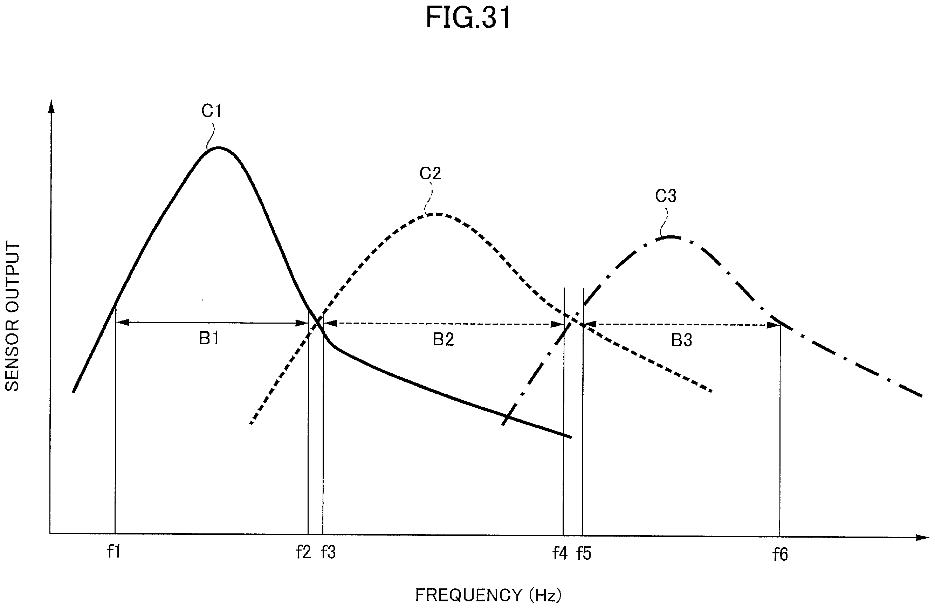

Here, the measurable frequency band B can be similarly expanded even when three or more OPMS 10 are provided in the magnetic measuring device 2. FIG. 31 is a diagram illustrating the frequency characteristics C1, C2, and C3 of each sensor output when the number of OPMS 10 is three. As illustrated in FIG. 31, the frequency band B1 of the first OPM 111 is determined by f1(Hz)-f2(Hz), the frequency band B2 of the second OPM 112 is determined by f3(Hz)-f4(Hz), and the frequency band B3 of the third OPM 10-3 is determined by f5(Hz)-f6(Hz). Accordingly, when the OPM 10 is three, the magnetic measuring device 2 is cable of further expanding the measurable frequency band B so as to be f1 to f6.

As described above, in the magnetic measuring device 2 according to the fourth embodiment, the external coil driver 21 applies the bias currents j1 and j2 of different values to the external coils 211 and 212 disposed in the plurality of an optical pumping atomic magnetometer 111 and 112. With this arrangement, the measurable frequency bands B1 and B2 of each of the plurality of an optical pumping atomic magnetometers 111 and 112 can be shifted to increase the measurable frequency band of the magnetic measuring device 2 as a whole. As a result, the magnetic measuring device 2 according to the fourth embodiment can measure the magnetic field in the frequency band of a wider range by the optical pumping atomic magnetometer 10.

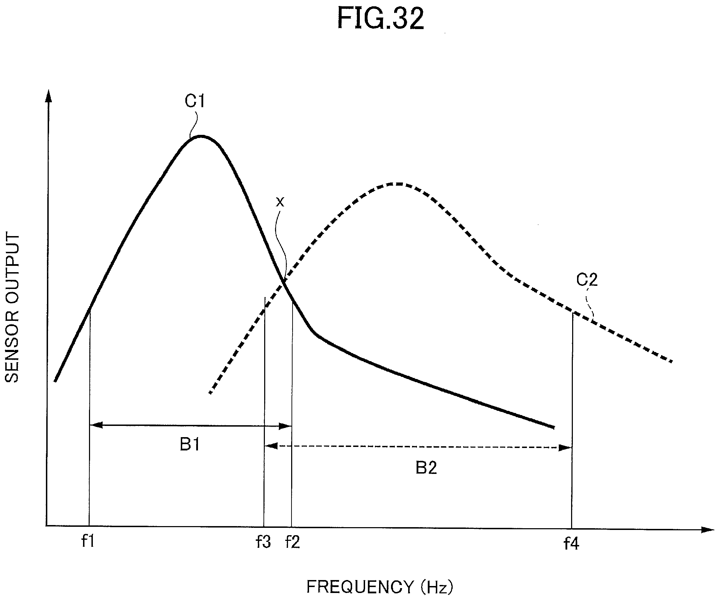

FIG. 32 is a diagram illustrating an embodiment in which the frequency characteristics C1 and C2 of the outputs of the first OPM 111 and the second OPM 112 are superposed. When a plurality of different OPM 10 frequency bands B are arranged differently, it is preferable that there is no gap between the frequency bands B1 and B2 of each OPM. This is because when there is a gap, the signal of the frequency to be detected cannot be measured. For this purpose, overlap may occur in adjacent frequency bands B1, B2 as illustrated in FIG. 32. In this example, the relationship between the high frequency side f2 of the frequency band B1 of the first OPM 111 and the low frequency side f3 of the frequency band B2 of the second OPM 112 is replaced by the relationship between the high frequency side f2 and the low frequency side f3 of the frequency band B2 of the second OPM 112, respectively, from the embodiment illustrated in FIG. 30. That is, f2 is larger than f3, and an upper limit portion of frequency band B1 of the first OPM 111 overlaps with the lower limit portion of frequency band B2 of the second OPM 112 adjacent to the high frequency side. The relationship between the frequencies f2 and f3 can be adjusted by the DC current applied to the external magnetic field.

Thus, in the fourth embodiment, the external coil driver 21 applies the bias currents j1 and j2 having different values to the external coils 211 and 212 of the multiple optical pumping atomic magnetometers 111 and 112 so that the upper limit portion of the frequency band B1 of one adjacent optical pumping atomic magnetometer (a first OPM 111) overlaps with the lower limit portion of the frequency band B2 of the other optical pumping atomic magnetometer (a second OPM 112). This arrangement eliminates the gap between the frequency bands B1 and B2 respectively of the adjacent OPMS 111 and 112, and can prevent an area where the magnetism cannot be measured from occurring. Therefore, magnetic measurement can be performed throughout the entire range including the frequency bands B1 and B2 respectively of the OPMS 111 and 112, and general use and convenience can be improved.

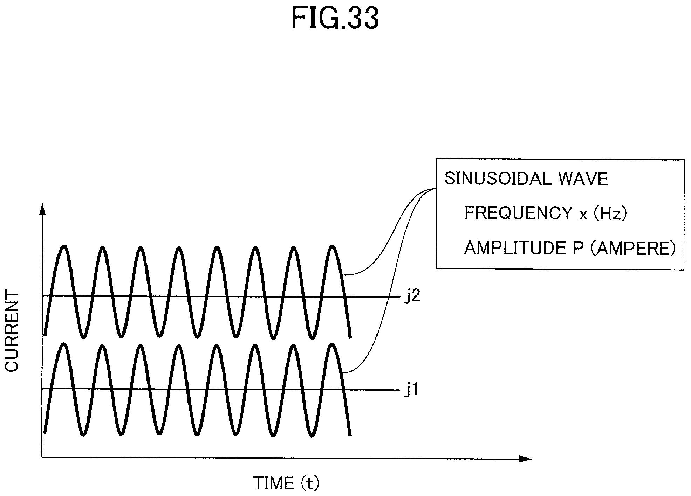

Further, as illustrated in FIG. 32, the frequency bands B1 and B2 are overlapped, so that calibration of the frequency characteristic C and the frequency band B can be performed among the multiple OPMS 10. The reason is that the output from the OPM 10 differs depending on the frequency band B to be used, and there are variations in the characteristics due to manufacturing errors and so-called individual variations. In addition to FIG. 32, a calibration procedure will be described with reference to FIGS. 33 to 36.

In FIG. 32, the frequency of an intersection between a right side skirt (high frequency side) of the frequency characteristic C1 of the first OPM 111 and a left side skirt (low frequency side) of the frequency characteristic C2 of the second OPM 112 is denoted by x (Hz).

The external coil driver 21 generates a sinusoidal wave (an alternating current) having a frequency of x (Hz) and an amplitude of P (amperes). This is superposed on the previously applied DC bias currents j1, j2 (or the sinusoidal wave is multiplied by the offset of j1, j2). FIG. 33 illustrates the waveforms of currents applied to each OPM 111, 112.

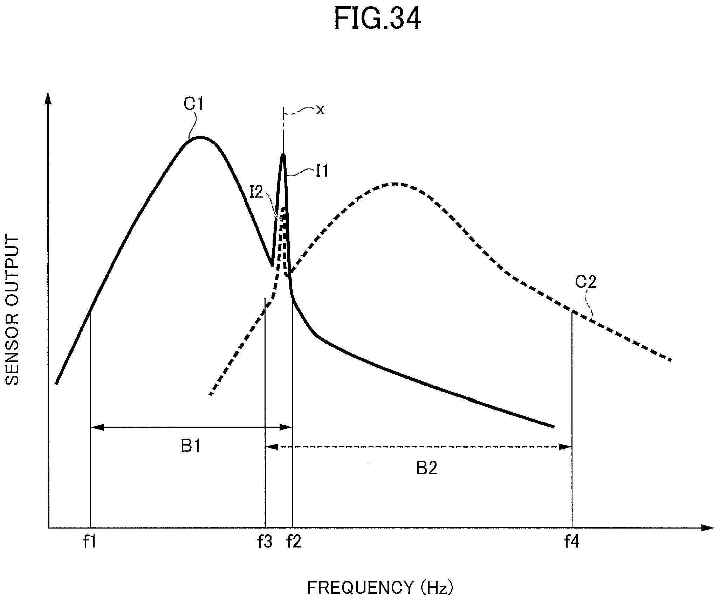

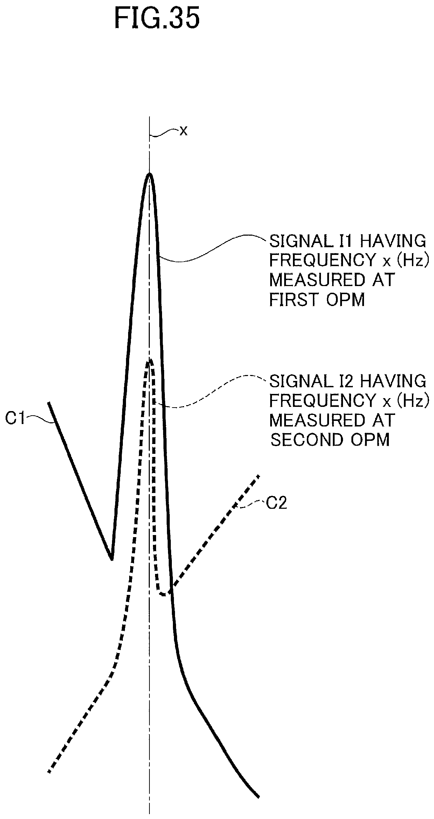

FIG. 34 is a diagram illustrating the frequency characteristics C1 and C2 respectively of the OPMS 111 and 112 when the current illustrated in FIG. 33 is applied. FIG. 35 is an enlarged view illustrating the vicinity of the magnetic field signals I1 and I2 illustrated in FIG. 34.

When the current having a waveform illustrated in FIG. 33 is applied to the external coils 211 and 212, an alternating magnetic field of frequency x (Hz) is generated. When this is measured by the OPMS 111 and 112, as illustrated in FIG. 34, in addition to the frequency characteristics C1 and C2 caused by the bias currents j1 and j2 of DC, the magnetic field signals I1 and I2 having peaks at the position of frequency x (Hz) are generated. The magnetic field signal I1 is an output when measured by the first OPM 111, and the magnetic field signal I2 is an output when measured by the second OPM 112. As illustrated in FIG. 35, the peak values of the magnetic field signal I1 and the magnetic field signal I2 are generally different. These differences are caused by an individual difference of sensors and frequency characteristics C1 and C2. However, because the sinusoidal waves superposed on the bias currents j1 and j2 are the same in both the first OPM 111 and the second OPM 112, two magnetic field signals I1 and I2 should essentially be the same.

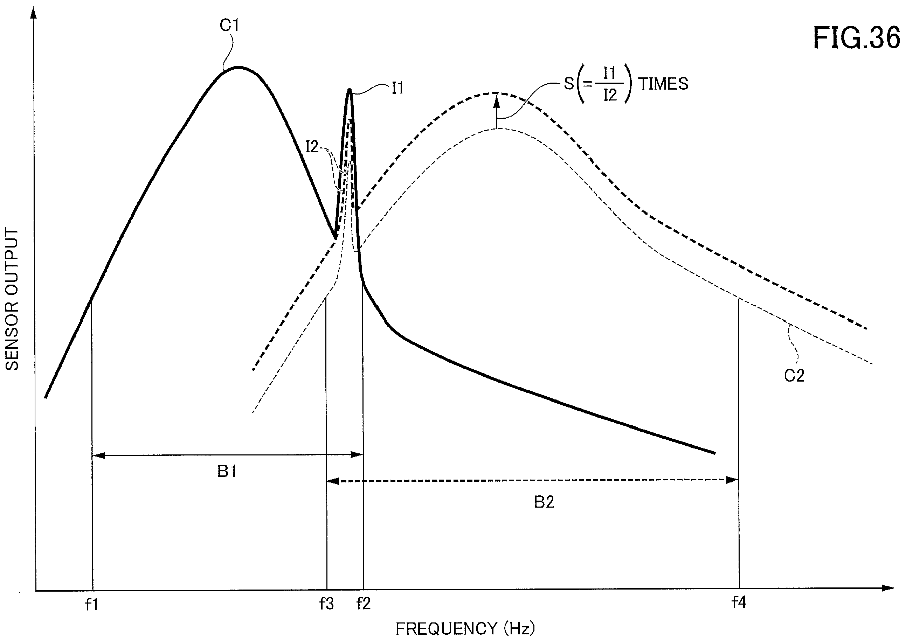

Therefore, in the fourth embodiment, the difference in the peak value between the magnetic field signal I1 and the magnetic field signal I2 is adjusted by an amplifier gain or the like. FIG. 36 is a diagram illustrating an example of gain adjustment of the frequency characteristic of the first OPM and the second OPM. As illustrated in FIGS. 34 and 35, the magnetic field signal I1 of the first OPM 111 and the magnetic field signal I2 of the second OPM 112 have a relationship of I1>I2, and when it is desired to align the peak values of I1 and I2, for example, the gain S is multiplied by the whole of the frequency characteristic C2 of the second OPM 112 where the gain S = I1/I2 (when the first OPM 111 is used as a reference). Therefore, the frequency characteristic C2 and the magnetic field signal I2 are corrected so that the frequency characteristic C2 and the magnetic field signal I2 are shifted in an increasing direction. As a result, the magnetic field signal I2 is corrected so that the magnetic field signal I1 is equal to the magnetic field signal I2.
In this way, by correcting the output of each OPM 10, the effect of the difference in the individual sensors and the difference in the frequency characteristic C can be reduced, and the measurement system can be uniformized throughout the frequency band B over which the magnetic measuring device 2 can measure.

Incidentally, the same calibration method is used when the number of OPMS 10 is three or more (N≥3). Alternatively, instead of adjusting the applied current as described above, the applied current may be software adjusted on measured data. Alternating current waves superposed on the bias signals j1 and j2 illustrated in FIG. 33 are not limited to a sinusoidal wave. For example, the alternating current waves may be a triangular wave or square wave.

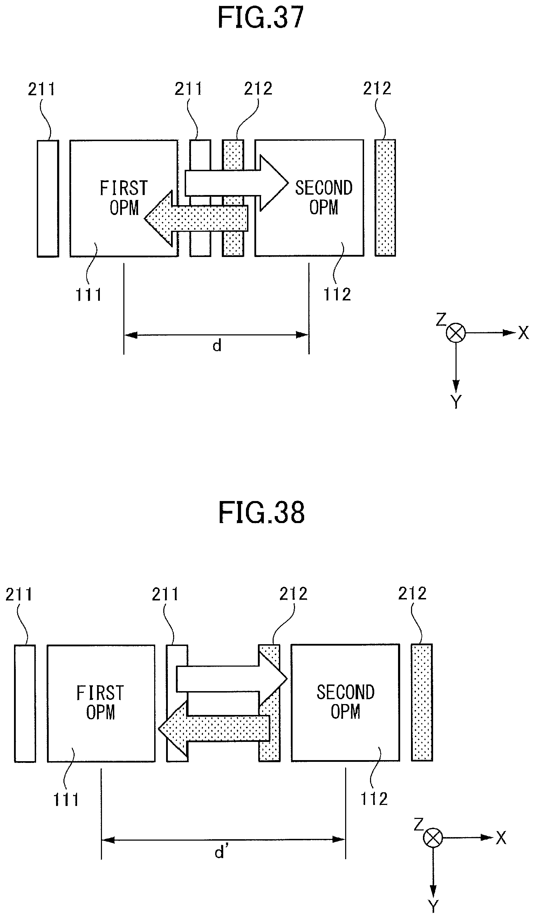

Crosstalk occurs when the distance between adjacent OPMS 10 is close. FIG. 37 is a schematic diagram illustrating two OPMS 111 and 112 in close proximity. FIG. 38 is a schematic diagram in which two OPMS 111 and 112 are spaced apart. As illustrated in FIGS. 37 and 38, as the distance between the first OPM 111 and the second OPM 112 approaches (d'→d), the first OPM 111 is strongly influenced by a bias magnetic field from the second external coil 212 (particularly the X negative side). Similarly, the second OPM 112 is also strongly influenced by a bias magnetic field from the first external coil 211 (particularly the X positive side). This is because the direction of the bias magnetic field is the same between the first OPM 111 and the second OPM 112. Therefore, it is preferable that the multiple OPMS 10 be separated from each other so as not to be affected by crosstalk.

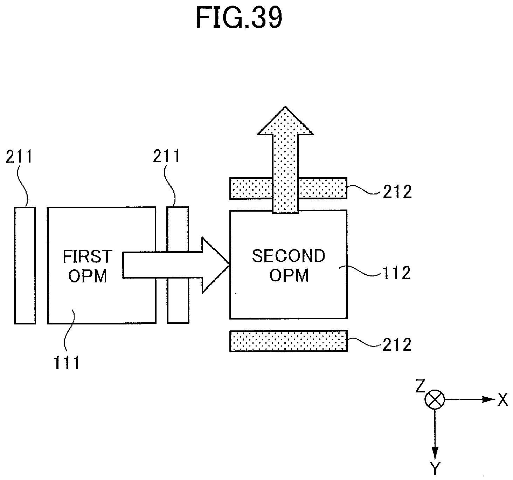

FIG. 39 is a schematic diagram of two OPMS 111 and 112 in which the coil opposing directions are changed and arranged. If the distance between the two OPMS 10 is not sufficient to be affected by crosstalk, one of them may be rotated 90° as illustrated in FIG. 39. This arrangement renders the adjacent OPMS 10 less susceptible to the bias magnetic field.

That is, in the structure of FIG. 39, the direction of the first external coil (the external coil 211) disposed in the adjacently disposed first optical pumping atomic magnetometer (the first OPM 111) and the second external coil (the external coil 212) disposed in the second optical pumping atomic magnetometer (the second OPM 112) is arranged so as to be orthogonal to the magnetic field generated by the first external coil and the magnetic field generated by the second external coil. This arrangement reduces the influence of the bias magnetic field and reduces the crosstalk even when the distance between the adjacent OPMS 111 and 112 is close to crosstalk when the facing directions of the external coils 20 of each OPM is the same.

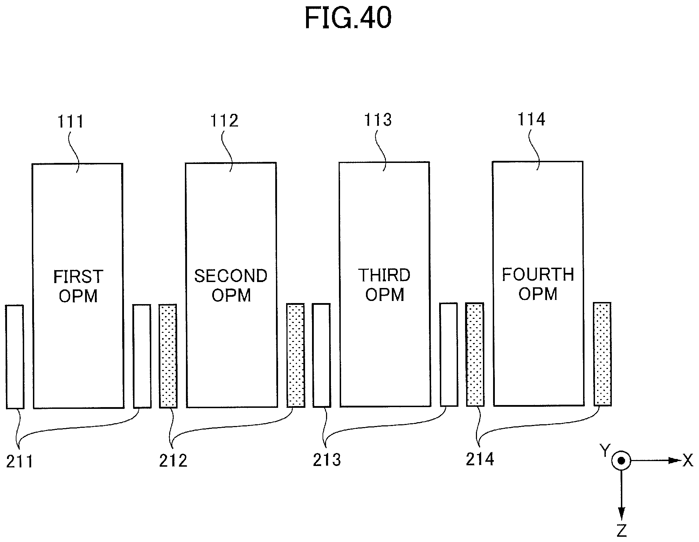

Referring to FIGS. 40 to 45, other structures for crosstalk reduction will be described. The crosstalk can also be reduced by a method of driving the multiple external coils 20.

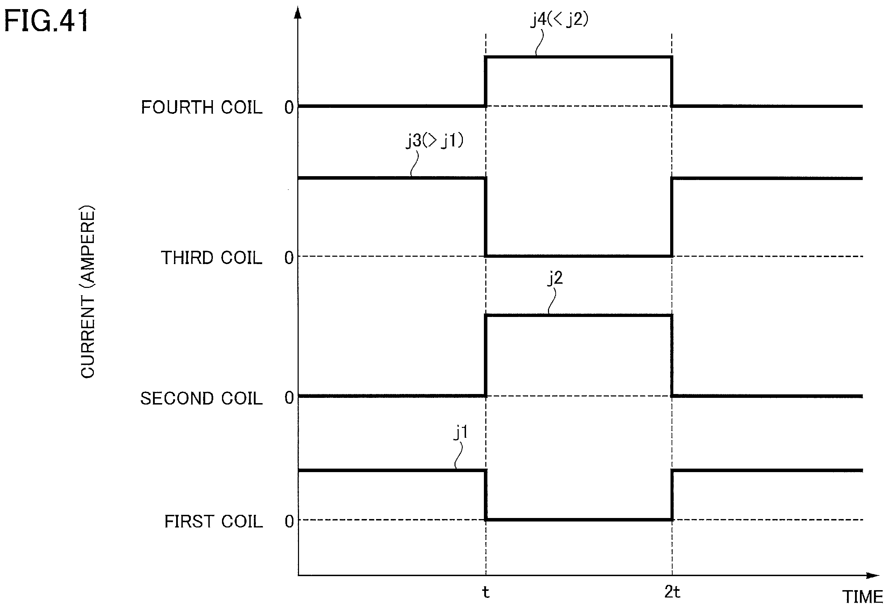

FIG. 40 is a diagram illustrating an example in which the four OPMS 111, 112, 113, and 114 are arranged in the same direction as the facing direction of the external coils. FIG. 41 is a diagram illustrating an example of current application control in the structure of FIG. 40. The axis of abscissa of FIG. 41 represents a time, and the axis of ordinate represents the current value of each coil 211, 212, 213, 214.

As illustrated in FIG. 40, a case where the first OPM 111, the second OPM 112, the third OPM 113, and the fourth OPM 114 are arranged along the X-direction in this order, and each of the first external coil 211, the second external coil 212, the third external coil 213, and the fourth external coil 214 are arranged so that the facing direction is the same (in the X-direction in FIG. 40).

For the structure of FIG. 40, as illustrated in FIG. 41, a current is applied simultaneously to the first and third external coils 211 and 213. The current values applied to the first external coil 211 and the third external coil 213 are different (j1<j3); these current values are zero simultaneously at the time t (sec); the current is applied simultaneously to the second and fourth external coils 212 and 214 at the time t; and the current values applied to the second and fourth external coils 212 and 214 are different (j2>j4). At the time 2t, these current values are zero and current is applied simultaneously to the first and third external coils 211 and 213. Thus, the application of the current to the first and third external coils 211 and 213 and the application of the current to the second and fourth external coils 212 and 214 are alternately repeated. In this manner, the four OPMS always drive one minute apart, thus reducing the crosstalk from the adjacent external coils 20. It should be noted that the number of parallel arrays of the OPM 10 is not limited to four, and more than four parallel arrays may be configured.

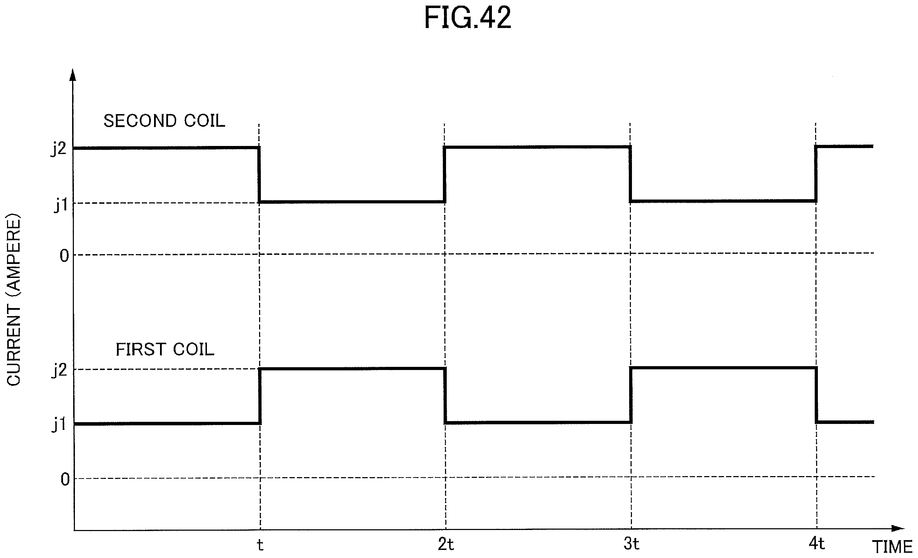

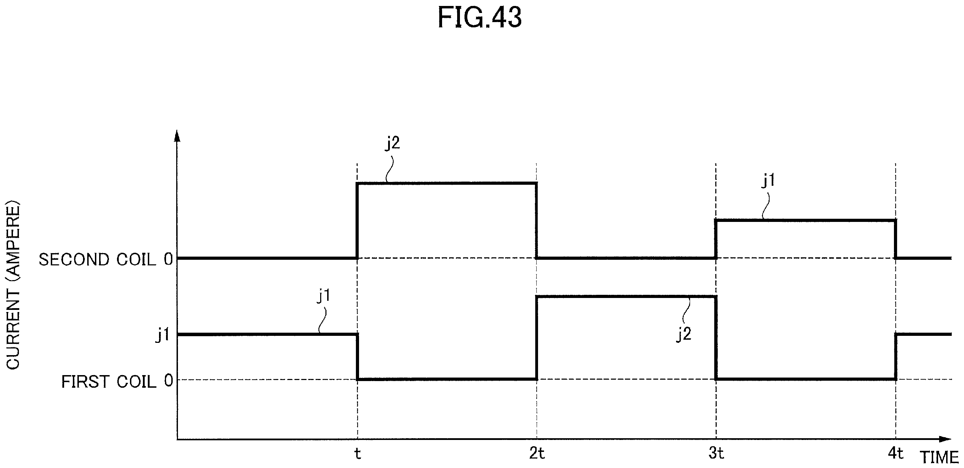

Other examples of a drive control between the adjacent OPMS 10 will be described with reference to FIGS. 42 and 43. FIG. 42 is a diagram illustrating a first current application pattern of another example of the drive control between the adjacent OPMS 10. FIG. 43 is a diagram illustrating a second current application pattern of another example of the drive control between the adjacent OPMS 10. FIGS. 42 and 43 illustrate the same structure as FIG. 41 and will be described with reference to two OPMS of the first OPM 111 and the second OPM 112 for simplification of the description.

As illustrated in FIG. 42, the bias currents j1 and j2 (two types) are respectively applied to the adjacent OPMS 111 and 112. In the first state, the bias current j1 is applied to the first external coil 211 and the bias current j2 is applied to the second external coil 212. In the second state, the bias current j2 is applied to the first external coil 211 and the bias current j1 is applied to the second external coil 212. The first and second states may be alternately repeated. With this structure, the bandwidth of each of the multiple OPMS 10 can be increased while also preventing an interference between the OPMS 10.

As illustrated in FIG. 43, the bias currents j1 and j2 (two types) are respectively applied to the adjacent OPMS 111 and 112, and the following operation may be repeated in the adjacent OPMS 111 and 112. In a first state, the bias current j1 is applied to the first external coil 211 and the bias current of zero is applied to the second external coil 212. In a second state, the bias current of zero is applied to the first external coil 211 and the bias current j2 is applied to the second external coil 212. In a third state, the bias current j2 is applied to the first external coil 211 and the bias current of zero is applied to the second external coil 212. In a fourth state, the bias current of zero is applied to the first external coil 211 and the bias current j1 is applied to the second external coil 212. The first to fourth states may be alternately repeated. With this arrangement, the bandwidth of each of the multiple OPMS 10 can be increased, and the crosstalk can be reduced because the adjacent OPMS 111, 112 are alternately turned on and off.

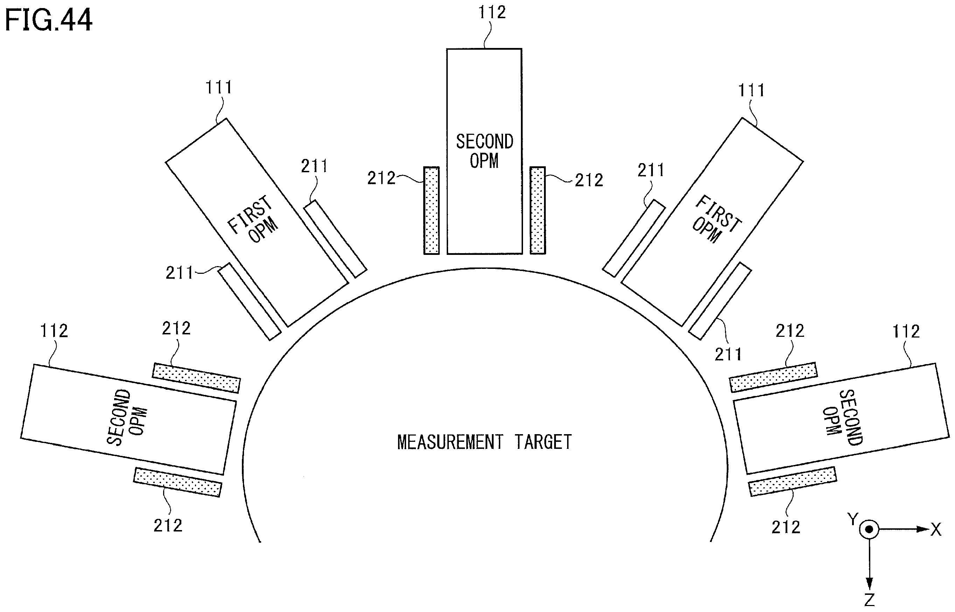

In the above description, the arrangements of the OPMS 10 have been made parallel to one another, but can be varied depending on the shape of the measurement target. FIG. 44 is a diagram illustrating an example of an arrangement of the multiple OPMS 10 in a case where the shape of the measurement target has a curved surface. As illustrated in FIG. 44, when the measurement target has a curved surface, the multiple OPMS 10 may be arranged along the curved surface while interposing a predetermined gap between the multiple OPMS 10 and the measurement target. For example, the measurement target having the curved surface is a head, neck, arm, or the like.

As described above, in the fourth embodiment, the multiple OPMS 10 (e.g., the first OPM 111 and the second OPM 112) with different frequency bands B are used to broaden the frequency band that can be measured by the entire device. Considered next is a case where a measurement area of the measurement target has a large area that is several times to several tens of times larger than the measurable area of one OPM 10. In this case, it is necessary to arrange the multiple OPMS 10 in the measurement area of the measurement target and arrange the frequency band B of each OPM 10 so as not to be biased.

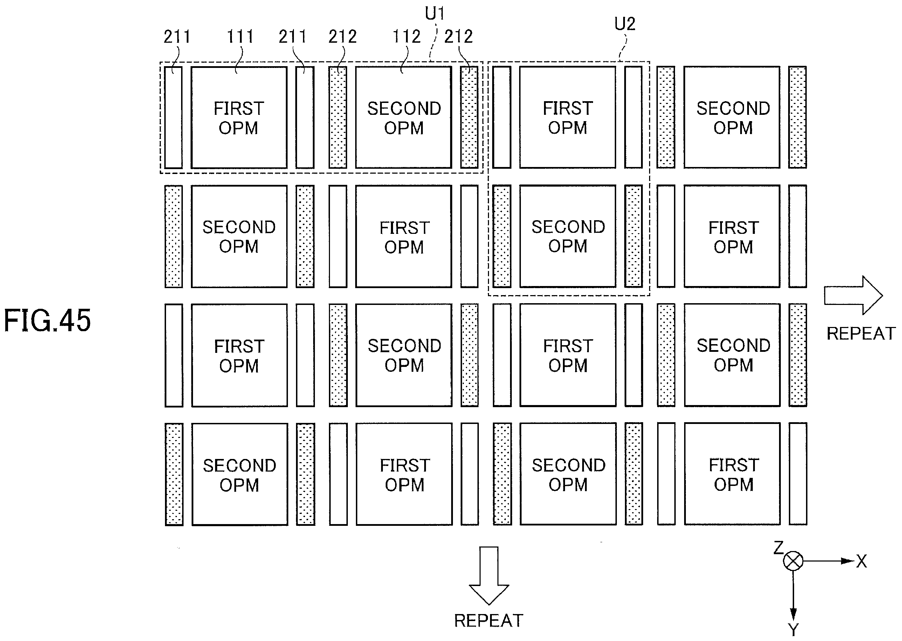

FIG. 45 is a diagram illustrating the first arrangement pattern of the multiple OPMS 10 in the case where the measurement area is a wide area.
In the example of FIG. 45, the multiple OPMS 111, 112 respectively having different frequency bands B1, B2 are alternately positioned along the X-direction and Y-direction. Further, the external coils 211 and 212 of the multiple OPMS 111 and 112 are arranged so that the facing directions between the external coils 211 and the OPM 111 and between the external coils 212 and the OPM 112 are the same. FIG. 45 illustrates a case where the two types of OPMS 111, 112 (for N=2) are used. In the fourth embodiment, the repeat units U1 and U2 (a structure in which the first OPM 111 and the second OPM 112 are adjacent to the X-direction or the Y-direction) of the multiple OPMS illustrated in FIG. 45 surrounded by dashed lines are the minimum unit for the magnetic measuring device 2, and the minimum unit can be expanded by combining a plurality of them.

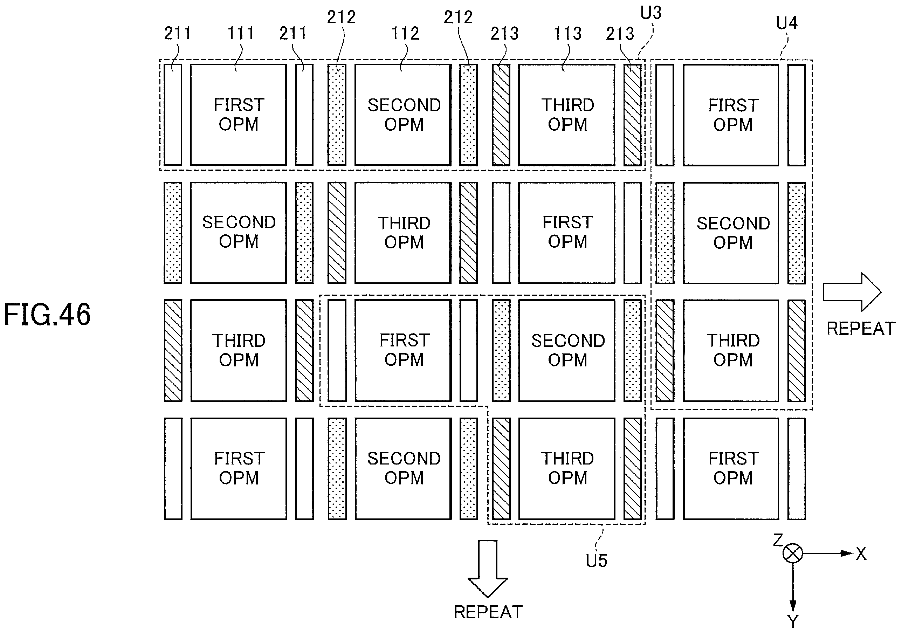

FIG. 46 is a diagram illustrating a first arrangement pattern for the three types of OPMS 111, 112, and 113. In the example of FIG. 46, the multiple OPMS 111, 112, and 113 having different frequency bands B1, B2, and B3 are arranged in order along the X-direction and Y-direction. The repeat units U3, U4, and U5 (a structure in which the first OPM 111, the second OPM 112, and the third OPM 113 are adjacent to the X-direction or the Y-direction) of the multiple OPMS surrounded by dashed lines illustrated in FIG. 46 are the minimum units of the magnetic measuring device 2, and the minimum units can be expanded by combining multiple minimum units.

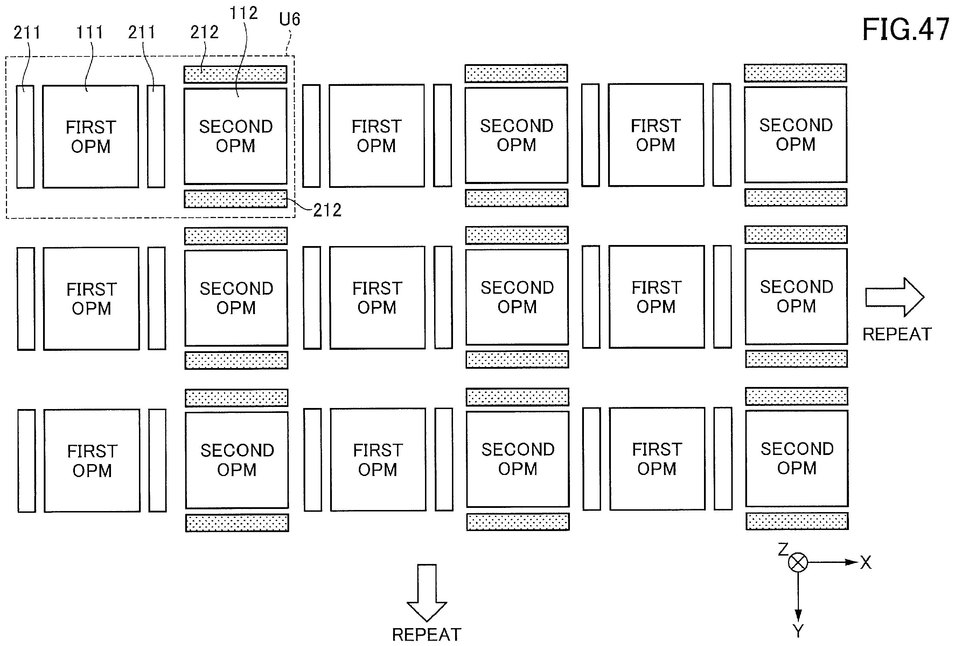

FIG. 47 is a diagram illustrating a second arrangement pattern of the multiple OPMS 10 in a case where the measurement area is a wide area. In the example of FIG. 47, the repeat unit U6 in which the facing direction of the external coils 211 and 212 of the first OPM 111 and the second OPM 112 illustrated in FIG. 39 is 90 degrees offset is repeated along the X-direction and the array in the X-direction is copied in the Y-direction. That is, the first OPM 111 or the second OPM 112 is continuously disposed in the Y-direction. As described with reference to FIG. 39, a crosstalk between adjacent first OPM 111 and second OPM 112 can be reduced in the arrangement pattern illustrated in FIG. 47. Further, FIG. 47 is an example of N=2, but the same applies to N equal to or greater than 3.

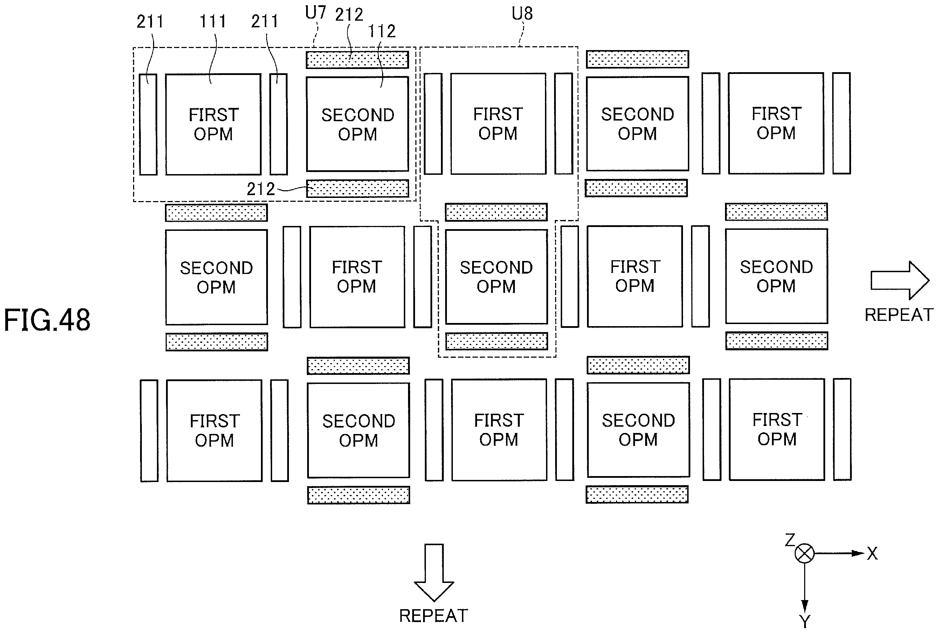

FIG. 48 is a diagram illustrating a third arrangement pattern of the multiple OPMS 10 in the case where the measurement area is a wide area. The arrangement pattern illustrated in FIG. 48 differs from the arrangement pattern illustrated in FIG. 47 in that the first OPM 111 and the second OPM 112 are disposed by differentiating the facing directions by 90 degrees along the Y-direction as well as in the X-direction. The repeat units U7 and U8 (a structure in which the first OPM 111 and the second OPM 112 are adjacent to the X-direction or the Y-direction) of the multiple OPMS illustrated in FIG. 48 surrounded by dashed lines are a minimum unit of the magnetic measuring device 2.

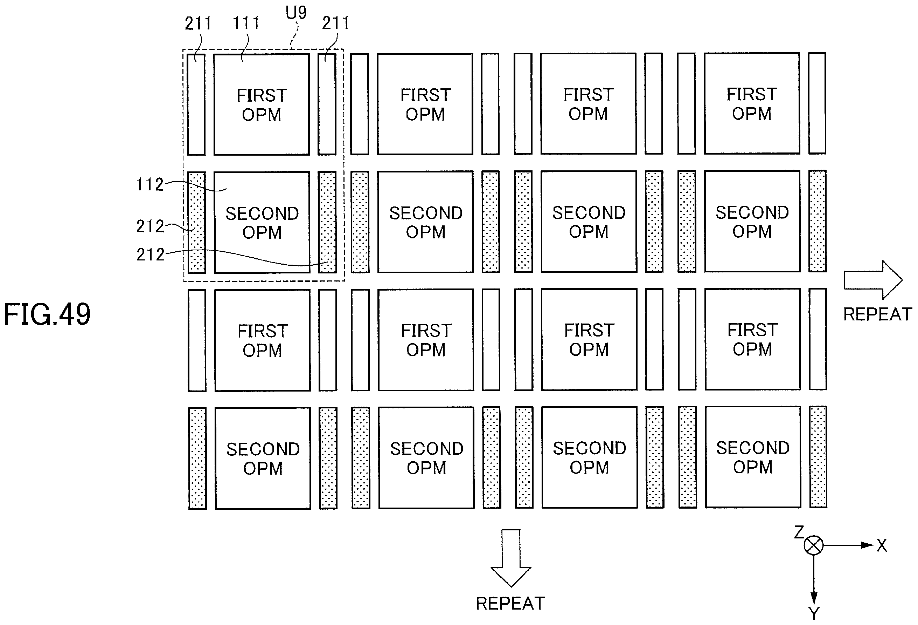

FIG. 49 is a diagram illustrating a fourth arrangement pattern of the multiple OPMS 10 in which the measurement area is a wide area. In the arrangement pattern illustrated in FIG. 49, a repeat unit U9 in which the first OPM 111 and the second OPM 112 are adjacent to each other in the Y-direction and the facing direction of the respective external coil 20 is in the X-direction is repeatedly disposed in the X-direction and the Y-direction.

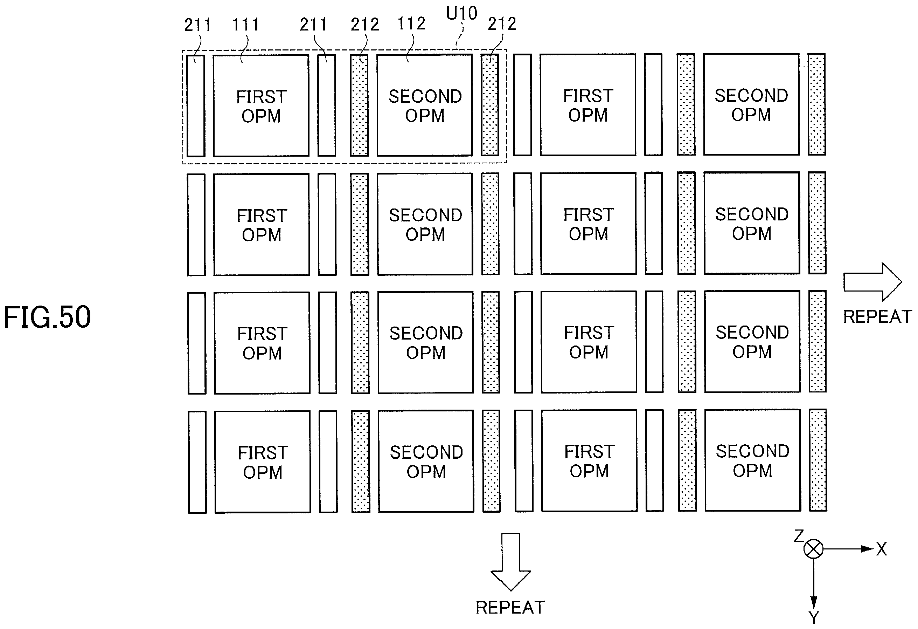

FIG. 50 is a diagram illustrating a fifth arrangement pattern of the multiple OPMS 10 in a case where the measurement area is wide. In the arrangement pattern illustrated in FIG. 49, a repeat unit U10 in which the first OPM 111 and the second OPM 112 are adjacent to each other in the X-direction and the facing direction of the respective external coil 20 is in the Y-direction is repeatedly arranged in the X-direction and the Y-direction.

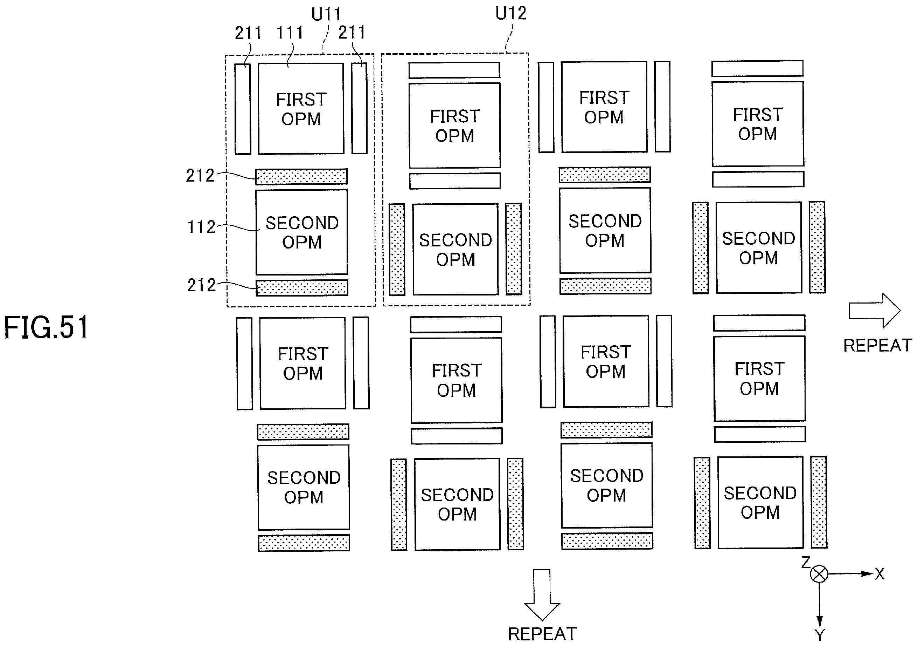

FIG. 51 is a diagram illustrating a sixth arrangement pattern of the multiple OPMS 10 in a case where the measurement area is a wide area. The arrangement pattern illustrated in FIG. 51 includes a first portion in which the first OPM 111 and the second OPM 112 are adjacent to each other in the Y-direction and a repeat unit U11 in which the facing direction of the first external coil 211 is in the X-direction and the facing direction of the second external coil 212 is in the Y-direction is repeatedly disposed along the Y-direction, and a second portion in which the first OPM 111 and the second OPM 112 are adjacent to each other in the Y-direction and the repeat unit U12 in which the facing direction of the first external coil 211 is in the Y-direction and the facing direction of the second external coil 212 is in the X-direction is repeatedly disposed along the Y-direction.

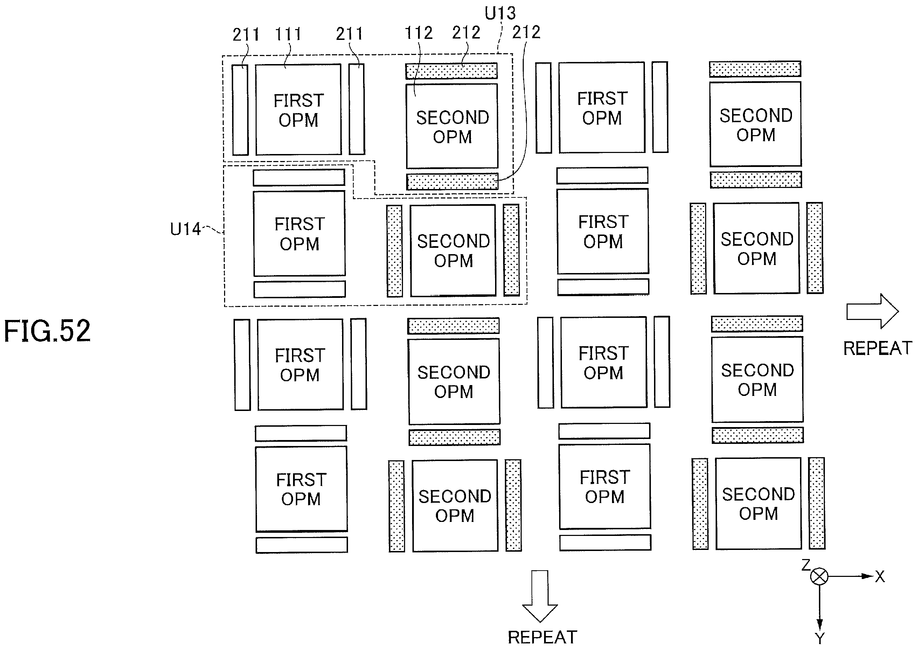

FIG. 52 is a diagram illustrating the seventh arrangement pattern of the multiple OPMS 10 in the case where the measurement area is a wide area.
The arrangement pattern illustrated in FIG. 52 includes a first portion and a second portion, which are alternately arranged in the Y-direction. In the first portion, the first OPM 111 and the second OPM 112 are adjacent to each other in the X-direction, and a repeat unit U13, in which the facing direction of the first external coil 211 is in the X-direction and the facing direction of the second external coil 212, is in the Y-direction is repeatedly arranged along the X-direction. In the second portion, the first OPM 111 and the second OPM 112 are adjacent to each other in the X-direction, and a repeat unit U14, in which the facing direction of the first external coil 211 is in the Y-direction and the facing direction of the second external coil 212 is in the X-direction, is repeatedly arranged along the X-direction.

The arrangement pattern of the multiple OPMS 10 illustrated in FIGS. 45 to 52 can be appropriately selected according to various measurement states such as the shape and size of the measuring portion of the biological magnetic field.

Thus, in the fourth embodiment, the multiple optical pumping atomic magnetometers 10 are arranged in at least one direction, and a plurality of sets (e.g., the repeat units U1 to U13 illustrated in FIGS. 45 to 52) in which the an optical pumping atomic magnetometer (e.g., first OPM 111, second OPM 112, third OPM 113) are arranged in a predetermined order in which a plurality of different bias currents are respectively applied along the arrangement direction are repeatedly arranged in the multiple sets. More particularly, the multiple optical pumping atomic magnetometers 10 are disposed so that the adjacent optical pumping atomic magnetometers 10 do not have the same frequency band B. With this structure, even in the case where the measurement area of the measurement target is large enough to be several times to several tens of times larger than the measurable area of one OPM 10, multiple OPMS having different frequency bands can be uniformly arranged throughout the measurement area in an even balance so as not to be biased, and a measurement condition and a measurement system such as the frequency band which can be measured can be uniformized across the entire measurement area.

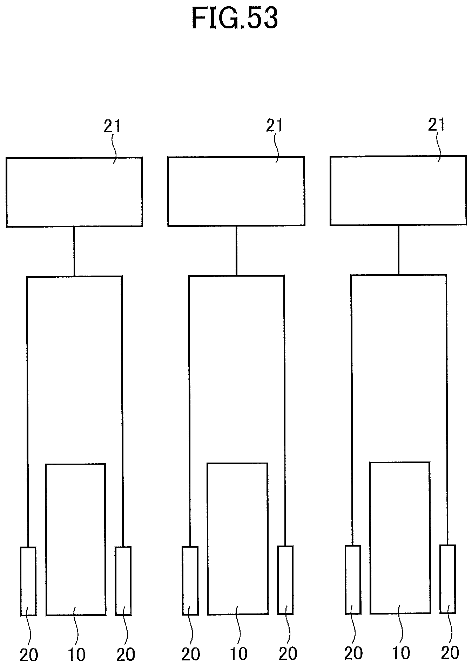

FIG. 53 is a diagram illustrating another structure example of the external coil driver 21.
As illustrated in FIG. 53, the external coil driver 21 may be provided one by one for each of the external coils 20. Further, if the multiple external coils 20 can be controlled by one external coil, the external coil driver 21 may be one in the entire apparatus as illustrated in FIG. 21 or the like.

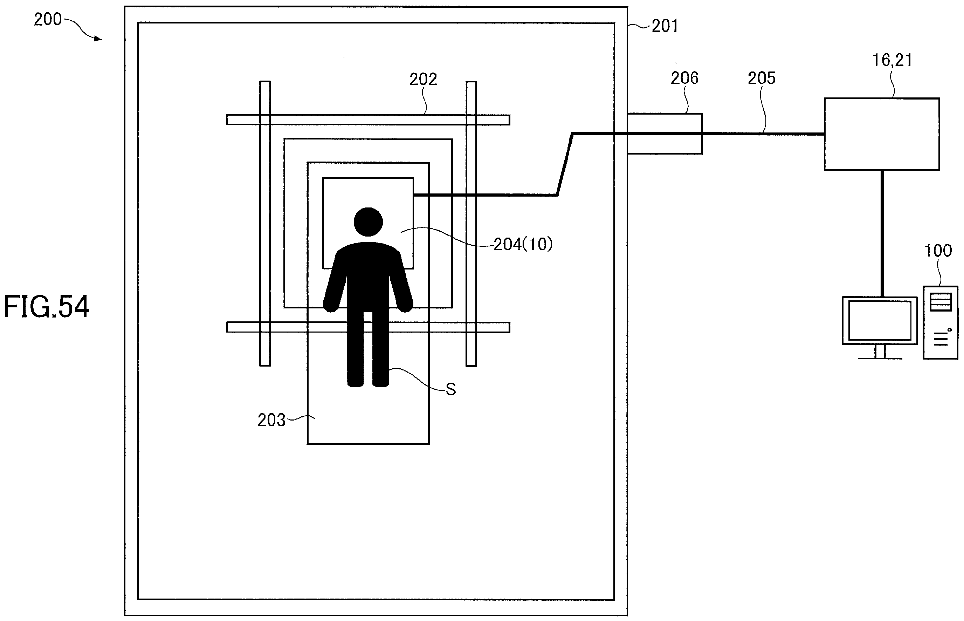

FIG. 54 is a diagram illustrating an example of the biomagnetic measuring system 200 using the magnetic measuring device 2. The biomagnetic measuring system 200 includes a magnetism shielding room 201, a measurement target S, a magnetism canceling coil 202, a bed 203, and an OPM array 204, wherein the measurement target S, the magnetism canceling coil 202, the bed 203, and the OPM array 204 are installed inside the magnetism shielding room 201. The measurement target S is, for example, a human being, and either moves the OPM array 204 depending on the measurement portion (e.g., the head) or takes a posture in which a subject moves the measurement portion to the position of the OPM array 204. The OPM array 204 is an arrangement pattern of the multiple OPMS 10 illustrated in FIGS. 45 to 52. Further, the OPM array 204 may be arranged along the curved surface as illustrated in FIG. 44, provided that the measuring portion has the curved surface like the head. The magnetism canceling coil 202 reduces the geomagnetic (magnetic field in the measuring environment) of the measurement portion or in the range of the OPM array 204, for example, a Helmholtz coil. The OPM array 204 is connected to the OPM controller 16 and the external coil driver 21 by a cable 205. To reduce noise, the OPM controller 16 and the external coil driver 21 are mounted outside the magnetism shielding room 201 and electrically connected to the OPM array 204 inside the magnetism shielding room 201 through a cable 205 and a port 206 provided on the outer wall of the magnetism shielding room 201. The OPM controller 16 and the external coil driver 21 are connected to the computer 100.

It is preferable that the dimensions of the OPM 10 be about 10 to several tens of millimeters on each side of the cross-sectional shape when the cross-section in the z-direction is rectangular as illustrated in FIG. 46, for example. The distance between the OPMS 10 when the multiple OPMS 10 is arranged is preferably about 10 to 30 mm. The frequency band B of the OPM 10 is preferably from a few kHz to several tens of kHz.

As described above, this embodiment has been described with reference to the specific examples. However, the present disclosure is not limited to these embodiments. Those embodiments, to which design modifications have been made from time to time by those skilled in the art, are also encompassed by the present disclosure as long as they possess the features of the present disclosure. The elements provided in each of the embodiments described above, and the arrangement, conditions, shape, and the like thereof, may be adapted and modified from time to time without being limited to those exemplified. Each element provided by each of the above-described embodiments may vary in combination as appropriate, unless there is a technical inconsistency.

### [Effects of the Invention]

An optical pumping atomic magnetometer can measure the magnetic field over a wider range of frequencies.

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority or inferiority of the invention. Although an information processing apparatus has been described in detail, it should be understood that various changes, substitutions, and alterations could be made thereto without departing from the spirit and scope of the invention.

## Claims

1. A magnetic measuring system comprising:
an optical pumping atomic magnetometer measuring a magnetic field emanated from a subject to be measured;
an external coil disposed around the optical pumping atomic magnetometer;
an external coil driver configured to drive the external coil; and
a stimulation application device configured to apply stimulation to the subject to be measured,
wherein the external coil driver outputs a plurality of types of command values to the external coil,
wherein the plurality of types of the command values is set so that a center frequency in a frequency characteristic of the optical pumping atomic magnetometer differs in response to an operation of the external coil in accordance with the command value, and
wherein the external coil driver sequentially changes the command value output to the external coil in response to the applying of the stimulation to the subject to be measured.

2. The magnetic measuring system according to claim 1, the magnetic measuring system further comprising:
a state detecting unit for detecting a state of the subject to be measured; and
a controller,
wherein the controller changes an output from the external coil driver and changes a center frequency of the frequency characteristic of the optical pumping atomic magnetometer based on information of the detected state of the subject to be measured and the information of the operation of applying the stimulation using the stimulation application device.

3. The magnetic measuring system according to claim 2, wherein the state detecting unit is a magnetic sensor that measures the magnetic field of the subject to be measured.

4. The magnetic measuring system according to any one of claims 1 to 3,
wherein the external coil driver transmits a plurality of command values to the external coil for the optical pumping atomic magnetometer that is single in number to cause the optical pumping atomic magnetometer to have a plurality of frequency characteristics having a different center frequency,
wherein the external coil driver applies an alternating current having a frequency at an intersection between a first frequency characteristic and a second frequency characteristic in the optical pumping atomic magnetometer while superposing a first bias current corresponding to a first command value for the first frequency characteristic and a second bias current corresponding to a second command value for the second frequency characteristic, and
wherein the first bias current or the second bias current is corrected so that a detected value of the frequency of the first frequency characteristic is same as a detected value of the frequency of the second frequency characteristic when the alternating current is superposed on the first bias current and the second bias current.

5. The magnetic measuring system according to any one of claims 1 to 4, the magnetic measuring system further comprising:
a plurality of optical pumping atomic magnetometers including the optical pumping atomic magnetometer;
a plurality of external coils including the optical pumping atomic magnetometer; and
a plurality of sets of one of the plurality of optical pumping atomic magnetometers and two of the plurality of the external coils.

6. The magnetic measuring system according to claim 5, wherein the external coil driver
applies to the external coil bias currents applied respectively to the external coils of two optical pumping atomic magnetometers, which are made of two of the optical pumping atomic magnetometers, such that the two optical pumping atomic magnetometers have a same center frequency while superposing the alternating current having an arbitrary frequency within a band of the frequency characteristic,
applies to the external coil an alternating current having a frequency at an intersection of a frequency characteristic of the optical pumping atomic magnetometer and another frequency characteristic of another optical pumping atomic magnetometer by superposing the alternating current on the bias current, and
corrects the bias current applied to the optical pumping atomic magnetometer or the another optical pumping atomic magnetometer so that a detected value of the frequency among the frequency characteristics of the optical pumping atomic magnetometer is same as a detected value of the frequency among the frequency characteristics of the another optical pumping atomic magnetometer when the alternating current is superposed on the bias current.

7. The magnetic measuring system according to any one of claims 1 to 6, the magnetic measuring system further comprising an environmental magnetic field reducing coil.

8. A magnetic measuring device comprising:
a plurality of optical pumping atomic magnetometers provided with external coils; and
an external coil driver,
wherein the external coil driver applies bias current having different values respectively to the external coils provided in the plurality of optical pumping atomic magnetometers.

9. The magnetic measuring device according to claim 8,
wherein the external coil driver applies bias currents having different values to the external coils for the plurality of optical pumping atomic magnetometers, respectively, so that an upper limit portion of a frequency band of one optical pumping atomic magnetometer of the plurality of optical pumping atomic magnetometers overlaps with a lower limit portion of the frequency band of another optical pumping atomic magnetometer of the plurality of optical pumping atomic magnetometers.

10. The magnetic measuring device according to claim 9, wherein the external coil driver
applies, to the external coil, an alternating current having a frequency at an intersection of a frequency characteristic of the optical pumping atomic magnetometer and another frequency characteristic of another optical pumping atomic magnetometer by superposing the alternating current on the bias current, and
corrects the bias current applied to the optical pumping atomic magnetometer or the another optical pumping atomic magnetometer so that a detected value of the frequency among the frequency characteristics of the optical pumping atomic magnetometer is same as a detected value of the frequency among the frequency characteristics of the another optical pumping atomic magnetometer when the alternating current is superposed on the bias current.

11. The magnetic measuring device according to any one of claims 8 to 10,
wherein, among the plurality of optical pumping atomic magnetometers, a direction of a first external coil adjacently disposed on a first optical pumping atomic magnetometer and a direction of a second external coil adjacently disposed on a second optical pumping atomic magnetometer are arranged so as to be respectively orthogonal with a magnetic field generated by the first external coil and a magnetic field generated by the second external coil.

12. The magnetic measuring device according to any one of claims 8 to 11,
wherein the plurality of optical pumping atomic magnetometers are arranged in at least one direction, and
each set of the optical pumping atomic magnetometers, each of which is applied with a plurality of different bias currents, arranged in a predetermined order, is further arranged to form a plurality of repeating sets along the at least one direction.

13. The magnetic measuring device according to claim 12,
wherein the plurality of optical pumping atomic magnetometers are arranged so that adjacent optical pumping atomic magnetometers do not have a same frequency band.

14. The magnetic measuring device according to claim 12 or 13, the magnetic measuring device further comprising:
a geomagnetism cancelling coil disposed on an outer periphery side of the plurality of optical pumping atomic magnetometers arranged in the at least one direction.
